# EUROPEAN PATENT APPLICATION

(11) **EP 4 761 222 A1**
(43) Date of publication of application: **17.06.2026**
(21) Application number: 24894389.6
(22) Date of filing: 23.10.2024
(51) Int. Cl.: H04M 1/02, H01Q 1/24, H04M 1/23, H05K 5/02, H05K 5/00

(54) **ELECTRONIC DEVICE COMPRISING ANTENNA MODULE**

(30) Priority: 20.11.2023 KR 20230161022
(71) Applicant: Samsung Electronics Co., Ltd., Suwon-si, Gyeonggi-do 16677 (KR)
(72) Inventor: KIM, Dongyeon, Suwon-si Gyeonggi-do 16677 (KR); PARK, Jongin, Suwon-si Gyeonggi-do 16677 (KR); HONG, Yumi, Suwon-si Gyeonggi-do 16677 (KR); YANG, Junyoung, Suwon-si Gyeonggi-do 16677 (KR); LEE, Gunho, Suwon-si Gyeonggi-do 16677 (KR); LEE, Hyojeong, Suwon-si Gyeonggi-do 16677 (KR); CHO, Youngsang, Suwon-si Gyeonggi-do 16677 (KR); CHOI, Seonghun, Suwon-si Gyeonggi-do 16677 (KR)
(74) Representative: HGF
(86) International application number: PCT/KR2024/016144
(87) International publication number: WO 2025/110495

(57) **Abstract**

This electronic device may comprise: a housing including a front surface, a rear surface facing the opposite direction of the front surface, and a side wall at least partially surrounding the space between the front surface and the rear surface; a camera assembly disposed adjacent to the side wall at one edge of the space; a cover plate disposed at at least a portion of the circumference of the camera assembly; a keypad assembly disposed between a first portion of the sidewall, which is at least partially adjacent to the camera assembly, and the camera assembly; and an antenna module of which a portion is disposed between a second portion of the sidewall adjacent to the first portion and the camera assembly, the antenna module including a first flexible printed circuit board disposed at least partially between the first portion and the camera assembly.

## Description

### [Technical Field]

The embodiment(s) of the disclosure relates to an electronic device, for example, an electronic device including an antenna module.

### [Background Art]

The term "electronic device" may refer to a device that performs a specific function based on an installed program, such as a home appliance, an electronic scheduler, a portable multimedia player, a mobile communication terminal, a tablet PC, a video/audio device, a desktop/laptop PC, or a vehicle navigation system. For example, these electronic devices may output stored information as sound or images. As the degree of integration of electronic devices increases and ultra-high-speed and high-capacity wireless communication become more widespread, a single electronic device, such as a mobile communication terminal, may be equipped with various functions. For example, not only communication functions but also entertainment functions such as gaming, multimedia functions such as music and video playback, communication and security functions for mobile banking or functions of schedule management or electronic wallet are being integrated into a single electronic device.

As the use of personal or portable communication devices, such as smartphones, has become common, user demands for portability and ease of use are increasing. For example, a touch screen display may provide a virtual keypad that replaces a mechanical input device (e.g., a button input device) while serving as an output device that outputs a screen (e.g., visual information). Accordingly, portable communication devices or electronic devices have come to be capable of providing the same or further improved usability (e.g., a larger screen) while being miniaturized. On the other hand, with the commercialization of flexible, for example, foldable or rollable displays, it is expected that the portability and ease of use of electronic devices will be further improved. An electronic device including a flexible display may be carried in a state in which multiple different structures (e.g., housings) are folded or rolled and may provide a large screen in an unfolded state, thereby improving portability and convenience of use.

The above-described information may be provided as related art for the purpose of helping to understand the disclosure. No claim or determination is made regarding whether any of the foregoing may be applied as prior art with respect to the disclosure.

### [Detailed Description of the Invention]

### [Technical Solution]

According to an embodiment of the disclosure, an electronic device may include a housing including a front surface, a rear surface facing opposite to the front surface, and a side wall at least partially surrounding a space between the front surface and the rear surface, a camera assembly disposed adjacent to the side wall at one edge of the space, a cover plate disposed on at least a portion of a circumference of the camera assembly and at least partially exposed to the outside through the rear surface, a keypad assembly disposed between a first portion of the side wall that is at least partially adjacent to the camera assembly and the camera assembly, and an antenna module having a portion disposed between a second portion of the side wall adjacent to the first portion and the camera assembly, the antenna module including a first flexible printed circuit board at least partially disposed between the first portion and the camera assembly. In an embodiment, the keypad assembly may include a switch substrate at least partially disposed between the first portion and the camera assembly, a second flexible printed circuit board extending from the switch substrate and disposed to cross the first flexible printed circuit board at one side of the camera assembly, and a dummy member disposed on the second flexible printed circuit board while at least partially facing the cover plate.

According to an embodiment of the disclosure, an electronic device may include a housing including a front surface, a rear surface facing opposite to the front surface, and a side wall at least partially surrounding a space between the front surface and the rear surface, a camera assembly disposed adjacent to the side wall at one edge of the space, a cover plate disposed on at least a portion of a circumference of the camera assembly and at least partially exposed to an outside through the rear surface, the cover plate providing a notch portion that is at least partially surrounded by a protrusion extending outward from an edge of the cover plate, a keypad assembly disposed between a first portion of the side wall that is at least partially adjacent to the camera assembly and the camera assembly, and an antenna module having a portion disposed between a second portion of the side wall adjacent to the first portion and the camera assembly, the antenna module including a first flexible printed circuit board at least partially disposed between the first portion and the camera assembly. In an embodiment, the keypad assembly may include a switch substrate at least partially disposed between the first portion and the camera assembly, a second flexible printed circuit board extending from the switch substrate and disposed to cross the first flexible printed circuit board at one side of the camera assembly, and a dummy member disposed on the second flexible printed circuit board and disposed to face the cover plate across an area in which the notch portion is disposed.

### [Brief Description of Drawings]

The above-described aspects or other aspects, configurations, and/or advantages regarding an embodiment of the disclosure may become more apparent through the following detailed description made with reference to the accompanying drawings.
FIG. 1 is a block diagram illustrating an electronic device according to an embodiment of the disclosure within a network environment.
FIG. 2 is a view illustrating an electronic device according to an embodiment of the disclosure in an unfolded state.
FIG. 3 is a view illustrating the electronic device according to an embodiment of the disclosure in a folded state.
FIG. 4 is an exploded perspective view of an electronic device according to an embodiment of the disclosure.
FIG. 5 is a view illustrating a state in which housings are coupled in an electronic device according to an embodiment of the disclosure.
FIG. 6 is a view illustrating a state in which hinge plates are disposed in an electronic device according to an embodiment of the disclosure.
FIG. 7 is a view illustrating an arrangement of one or more hinge modules and electronic components inside an electronic device according to an embodiment of the disclosure.
FIG. 8 is a perspective view illustrating a contact piece of an electronic device according to an embodiment of the disclosure.
FIG. 9 is a perspective view illustrating a state in which the contact piece is disposed in an electronic device according to an embodiment of the disclosure.
FIG. 10 is a view illustrating a camera assembly of an electronic device according to an embodiment of the disclosure.
FIG. 11 is a perspective view illustrating a third camera among the camera assembly of FIG. 10 in an electronic device according to an embodiment of the disclosure.
FIG. 12 is a first view illustrating a circuit board of an electronic device according to an embodiment of the disclosure.
FIG. 13 is a second view illustrating the circuit board of the electronic device according to an embodiment of the disclosure.
FIG. 14 is a view illustrating a state in which the camera assembly of FIG. 11 and the circuit board of FIG. 13 are disposed in a housing of an electronic device according to an embodiment of the disclosure.
FIG. 15 is a perspective view illustrating an antenna module of an electronic device according to an embodiment of the disclosure.
FIG. 16 is a perspective view illustrating a process in which the antenna module of FIG. 15 is disposed in the housing of the electronic device according to an embodiment of the disclosure.
FIG. 17 is a view illustrating a state in which the antenna module of FIG. 15 is disposed in the housing of the electronic device according to an embodiment of the disclosure.
FIG. 18 is a view illustrating a portion of the electronic device according to an embodiment of the disclosure, taken along line A-A' of FIG. 17.
FIG. 19 is a first perspective view illustrating a keypad assembly of an electronic device according to an embodiment of the disclosure.
FIG. 20 is a second perspective view illustrating the keypad assembly of the electronic device according to an embodiment of the disclosure.
FIG. 21 is a view illustrating a state in which the keypad assembly of FIG. 19 or FIG. 20 is disposed in a housing of an electronic device according to an embodiment of the disclosure.
FIG. 22 is a cross-sectional view illustrating a portion of the electronic device according to an embodiment of the disclosure, taken along line B-B' of FIG. 21.
FIG. 23 is a cross-sectional view illustrating a portion of the electronic device according to an embodiment of the disclosure, taken along line C-C' of FIG. 21.
FIG. 24 is a view illustrating a state in which one or more flexible printed circuit boards are disposed in an electronic device according to an embodiment of the disclosure.
FIG. 25 is a cross-sectional view illustrating a portion of the electronic device according to an embodiment of the disclosure, taken along line D-D' of FIG. 24.
FIG. 26 is a first view illustrating a state in which a cover plate is disposed in an electronic device according to an embodiment of the disclosure.
FIG. 27 is a second view illustrating a state in which the cover plate is disposed in the electronic device according to an embodiment of the disclosure.
FIG. 28 is a view illustrating a state in which a dummy member is disposed on an inner side of a cover plate in an electronic device according to an embodiment of the disclosure.

Throughout the appended drawings, like reference numerals may be assigned to like components, configurations, and/or structures.

### [Mode for Carrying out the Invention]

In addition to connections through commercial communication networks, communication protocols such as Bluetooth or Wi-Fi may provide an environment that enables direct wireless communication between different electronic devices. For example, an electronic device may perform wireless communication based on different protocols by including a plurality of antennas. However, as performance becomes more sophisticated, it may be difficult to secure space for disposing a plurality of antennas and/or wiring space for transmitting wireless signals to the antennas in electronic devices that are reduced in size or weight. Coaxial cables or flexible printed circuit boards may be useful as wiring for transmitting wireless signals to antennas, but in miniaturized electronic devices such as smartphones, these components may be disposed adjacent to other structures and may generate electromagnetic coupling or induced currents. Electromagnetic coupling or induced currents generated on a transmission line may degrade the efficiency of wireless communication or distort transmitted signals. On the other hand, since coaxial cables or flexible printed circuit boards have elasticity, shapes thereof after assembly may vary among different electronic devices manufactured with the same specifications. For example, when an electronic device is reduced in size, variations in wireless communication performance may occur depending on the product.

An embodiment of the disclosure is intended to at least address the above-described problems and/or disadvantages and to at least provide advantages described below, and may provide an electronic device including an antenna module that is disposed in a limited space while implementing a stable wireless communication environment.

An embodiment of the disclosure may provide an electronic device including an antenna module that provides substantially uniform wireless communication performance across different products having the same specifications.

The technical issues to be addressed by the disclosure are not limited to those described above, and other technical issues not mentioned above may be clearly understood by a person ordinarily skilled in the related art to which the disclosure pertains.

The following description with reference to the appended drawings may provide an understanding of various exemplary implementations of the disclosure, including the claims and their equivalents. An exemplary embodiment disclosed in the following description includes various specific details to help understanding, but is considered to be one of various exemplary embodiments. Accordingly, it will be understood by a person ordinarily skilled in the art that various implementations described herein may be variously changed and modified without departing from the scope and spirit of the disclosure. In addition, descriptions of well-known functions and configurations may be omitted for clarity and conciseness.

The terms and words used in the following description and claims are not limited to a bibliographical meaning, but may be used to describe an embodiment of the disclosure clearly and consistently. Accordingly, it will be apparent to those skilled in the art that the following description of various implementations of the disclosure is provided for explanatory purposes and not intended to limit the scope of the disclosure and equivalents thereof.

Unless the context clearly indicates otherwise, the singular forms of "a," "an," and "the" should be understood to include the plural meaning. Accordingly, for example, the term "a component surface" may be understood to include one or more surfaces of the component.

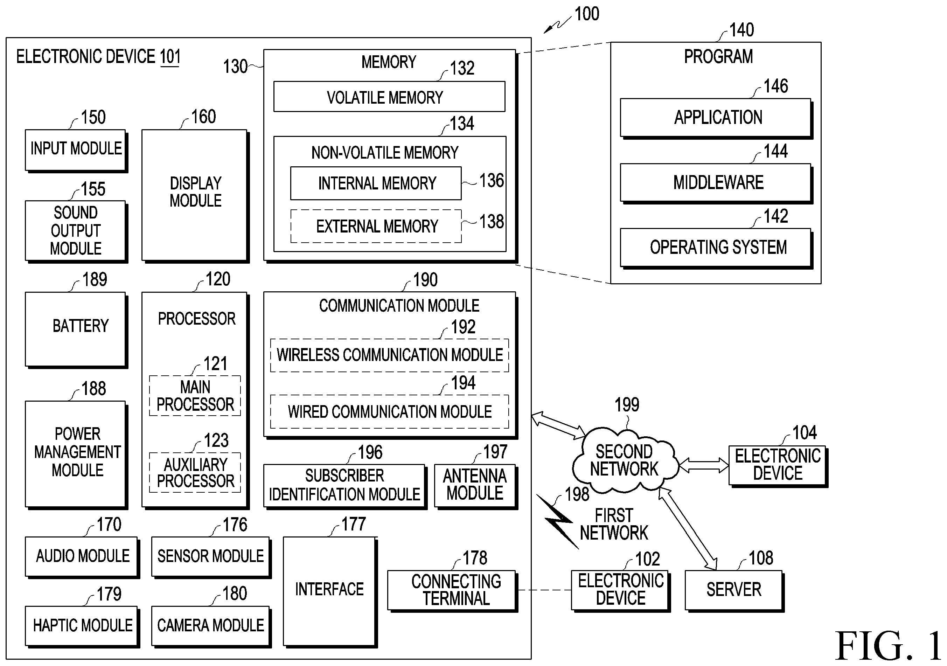

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program) including one or more instructions that are stored in a storage medium (e.g., internal memory or external memory) that is readable by a machine (e.g., the electronic device). For example, a processor (e.g., the processor) of the machine (e.g., the electronic device) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to an embodiment, the integrated component may still perform one or more functions of each of the plurality of components in the same or similar manner as they are performed by a corresponding one of the plurality of components before the integration. According to an embodiment, operations performed by the module, the program, or another component may be carried out sequentially, in parallel, repeatedly, or heuristically, or one or more of the operations may be executed in a different order or omitted, or one or more other operations may be added.

In the following detailed description, the length direction, the width direction, and/or the thickness direction of an electronic device may be referred to, wherein the length direction may be defined as the "Y-axis direction," the width direction may be defined as the "X-axis direction," and/or the thickness direction may be defined as the "Z-axis direction." In an embodiment, the direction in which a component is oriented may be mentioned along with the orthogonal coordinate system illustrated in the drawings, as well as the "negative/positive (-/+)." For example, the front side of an electronic device and/or a housing may be defined as a "side oriented in the +Z direction," and the rear side may be defined as a "side oriented in the -Z direction." In an embodiment, a side surface of an electronic device and/or a housing may include an area oriented in the +X direction, an area oriented in the +Y direction, an area oriented in the -X direction, and/or an area oriented in the -Y direction. In an embodiment, the "X-axis direction" may include both the "-X direction" and the "+X direction." It is noted that these are based on the Cartesian coordinate system illustrated in the drawings for the sake of brevity of description, and the descriptions of these directions or components do not limit the embodiment(s) of the disclosure. For example, depending on the design specifications of an electronic device or a user's usage habits, the Cartesian coordinate system may be defined differently from the disclosure.

In the embodiments described below, a plurality of housings are rotatably coupled to each other and are rotatable relative to each other between a first position in which the housings are folded to face each other and a second position in which the housings are unfolded to be arranged side by side on one side thereof. In the embodiments described below, descriptions referring to an orthogonal coordinate system in describing the embodiment(s) of an electronic device may generally be provided based on an unfolded state. In an electronic device of the embodiments described below, at least one folding axis may be understood as being substantially parallel to the Y-axis direction. However, the embodiment(s) of the disclosure is not limited thereto, and may be understood to include an electronic device having a structure in which one or more folding axes are parallel to an X-axis direction.

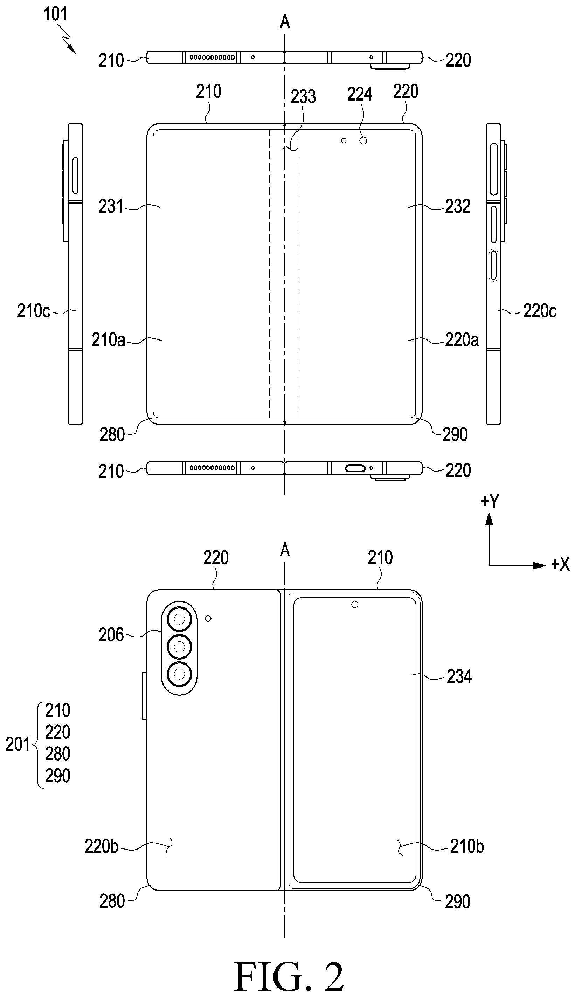

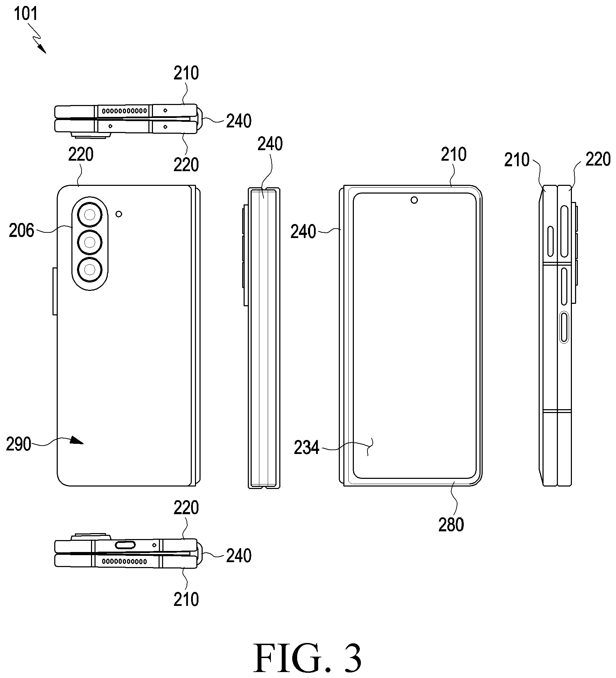

FIG. 2 is a view illustrating an electronic device according to an embodiment of the disclosure in an unfolded state. FIG. 3 is a view illustrating the electronic device according to an embodiment of the disclosure in a folded state.

Referring to FIGS. 2 and 3, an electronic device 101 may include a housing 201, a hinge cover 240 configured to cover a foldable portion of the housing 201, and a display 230 disposed in a space formed by the housing 201. According to an embodiment, a side of the display 230, on which an output screen is exposed, may be defined as a front side of the electronic device 101 (e.g., a first front side 210a and a second front side 220a). The side opposite to the front side may be defined as the rear side (e.g., a first rear side 210b and a second rear side 220b) of the electronic device 101. In an embodiment, a side surrounding the space between the front and rear sides may be defined as a side surface (e.g., a first side surface 210c and a second side surface 220c) of the electronic device 101. The side surface of the electronic device 101 may be the side surface of at least one of the first housing 210 or the second housing 220. The electronic device 101 of FIGS. 2 and 3 may be referred to as a "foldable electronic device," a "portable electronic device," or a "portable foldable electronic device." According to an embodiment, the housing 201 may be referred to as a "foldable housing." The display 230 may be referred to as a "flexible display."

According to an embodiment, the housing 201 may include a first housing 210, a second housing 220 rotatable with respect to the first housing 210, a first rear surface cover 280, and a second rear surface cover 290. The housing 201 of the electronic device 101 is not limited to the shape and assembly illustrated in FIGS. 2 and 3, but may be implemented by combinations and/or assemblies of other shapes or components. For example, in an embodiment, the first housing 210 and the first rear surface cover 280 may be integrated, and the second housing 220 and the second rear surface cover 290 may be integrated.

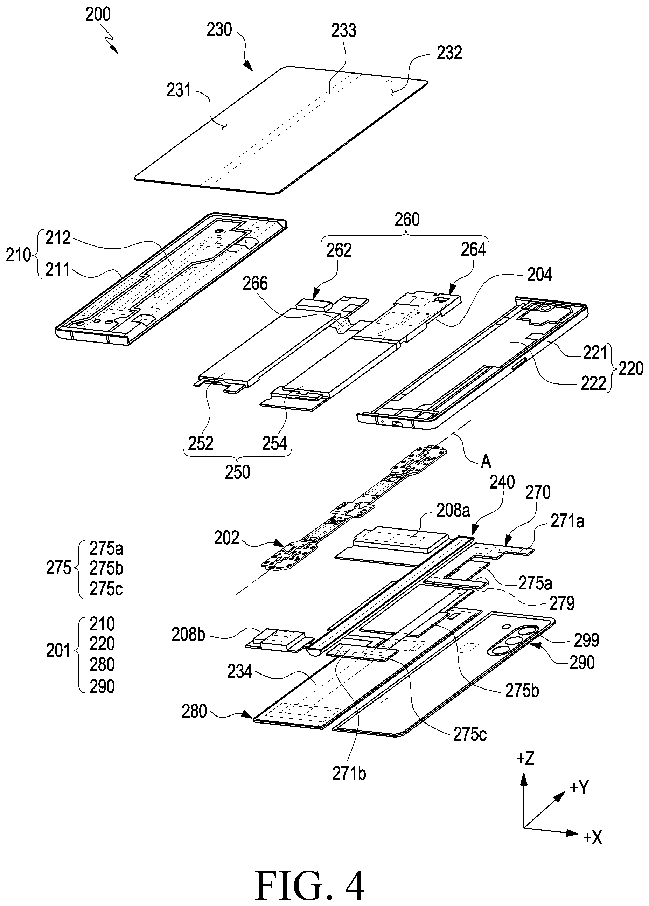

According to an embodiment, the first housing 210 may be connected to a hinge structure (e.g., the hinge assembly 202 of FIG. 4) and may include a first front surface 210a oriented in a first direction and a first rear surface 210b oriented in a second direction opposite to the first direction. The second housing 220 may be connected to the hinge assembly 202 and may include a second front surface 220a oriented in a third direction and a second rear surface 220b oriented in a fourth direction opposite to the third direction, and may be rotatable with respect to the first housing 210 about the hinge assembly 202. Accordingly, the electronic device 101 may be changed to a folded state or an unfolded state. The folding or unfolding operation of the electronic device 101 may be understood as a rotation of the first housing 210 relative to the hinge structure or a rotation of the second housing 220 with respect to the hinge structure. When the electronic device 101 is in the folded state, the first front surface 210a may face the second front surface 220a, and when the electronic device 101 is in the unfolded state, the third direction may be the same as the first direction. Hereinbelow, unless otherwise stated, directions will be described with reference to the unfolded state of the electronic device 101.

According to an embodiment, the first housing 210 and the second housing 220 may be disposed on opposite sides about the folding axis A and may have generally symmetrical shapes with respect to the folding axis A. As will be described later, the angle or distance between the first housing 210 and the second housing 220 may vary depending on whether the electronic device 101 is in the unfolded state, in the folded state, or in the intermediate state. According to an embodiment, the second housing 220 additionally includes a sensor area 224 where sensors (e.g., a front camera) are disposed, but the second housing 220 may have a mutually symmetrical shape in other areas.

According to an embodiment, the folding axis A may be implemented as a plurality of (e.g., two) folding axes arranged in parallel. In the disclosure, the folding axis A is provided along the length direction (the Y-axis direction) of the electronic device 101, but the direction of the folding axis A is not limited thereto. For example (not illustrated), an embodiment, in which the electronic device 101 includes a folding axis extending in the width direction (e.g., the X-axis direction), may be implemented.

According to an embodiment, the electronic device 101 may include a structure to which a digital pen (not illustrated) is attachable. For example, the electronic device 101 may include a magnetic body configured to attach the digital pen to the side surface of the first housing 210 or the side surface of the second housing 220. According to an embodiment, the electronic device 101 may include a structure into which a digital pen is insertable. For example, a hole (not illustrated) into which the digital pen is insertable may be provided in the side surface of the first housing 210 or the side surface of the second housing 220 of the electronic device 101.

According to an embodiment, the first housing 210 and the second housing 220 may be at least partially made of a metal or non-metal material having rigidity in a level selected in order to support the display 230. The at least a portion made of the metal material may provide a ground plane of the electronic device 101, and may be electrically connected to a ground line provided on a printed circuit board (e.g., the board unit 260 in FIG. 4).

According to an embodiment, the sensor area 224 may have a predetermined area adjacent to an edge or a corner of the second housing 220. According to an embodiment, the arrangement, shape, and size of the sensor area 224 are not limited to the illustrated examples. For example, in another embodiment, the sensor area 224 may be provided in any area between another corner or an upper end corner and a lower end corner of the second housing 220 or in the first housing 210. In an embodiment, components embedded in the electronic device 101 to carry out various functions may be exposed on the front side of the electronic device 101 through the sensor area 224 or through one or more openings provided in the sensor area 224. In an embodiment, the components may include various types of sensors. The sensors may include, for example, at least one of a front camera, a receiver, or a proximity sensor.

According to an embodiment, the first rear surface cover 280 may be disposed on one side of the folding axis A on a rear surface of the electronic device 101 and may have, for example, a substantially rectangular periphery, which may be surrounded by other structures of the first housing 210. Similarly, the second rear surface cover 290 is disposed on the other side of the folding axis A on the rear surface of the electronic device 101, and an edge thereof may be surrounded by other structures of the second housing 220.

According to an embodiment, the first rear surface cover 280 and/or the second rear surface cover 290 may have a substantially symmetrical shape about the folding axis A. However, the first rear surface cover 280 and the second rear surface cover 290 do not necessarily have mutually symmetrical shapes, and in an embodiment, the electronic device 101 may include the first rear surface cover 280 and the second rear surface cover 290 having different, asymmetrical shapes.

According to an embodiment, the first rear surface cover 280, the second rear surface cover 290, the first housing 210, and the second housing 220 may provide a space in which various components (e.g., a printed circuit board or a battery) of the electronic device 101 may be disposed. According to an embodiment, one or more components may be disposed or visually exposed on the rear side of the electronic device 101. For example, at least a portion of a sub-display 234 may be visually exposed through at least a portion of the first rear surface cover 280. In another embodiment, one or more components or sensors may be visually exposed through at least a portion of the second rear surface cover 290. In various embodiments, the sensors may include a proximity sensor and/or a camera module 206 (e.g., a rear camera).

According to an embodiment, a front camera exposed to the front surface of the electronic device 101 through one or more openings provided in the sensor area 224 or a camera module 206 exposed through at least a portion of the second rear surface cover 290 may include one or more lenses, an image sensor, and/or an image signal processor. In some embodiments, two or more lenses (e.g., an infrared camera lens, a wide-angle lens, and a telephoto lens) and image sensors may be disposed on one side of the electronic device 101.

According to an embodiment, the hinge cover 240 may be disposed between the first housing 210 and the second housing 220 to cover internal components (e.g., the hinge assembly 202 of FIG. 4). According to an embodiment, the hinge cover 240 may be covered by a portion of the first housing 210 and a portion of the second housing 220, or may be exposed to the outside depending on the state of the electronic device 101 (the unfolded state (flat state) or the folded state).

According to an embodiment, as illustrated in FIG. 2, when the electronic device 101 is in the unfolded state, the hinge cover 240 may not be exposed by being covered by the first housing 210 and the second housing 220. As another example, as illustrated in FIG. 3, when the electronic device 101 is in the folded state (e.g., the fully folded state), the hinge cover 240 may be exposed to the outside between the first housing 210 and the second housing 220. As another example, when the first housing 210 and the second housing 220 are in the intermediate state in which the first and second housings are folded with a certain angle therebetween, the hinge cover 240 may be partially exposed to the outside between the first housing 210 and the second housing 220. However, in this case, the exposed area may be smaller than that in the fully folded state. In an embodiment, the hinge cover 240 may include a curved surface.

In an embodiment, the display 230 may be disposed in the space provided (or defined) by the housing 201. For example, the display 230 may be seated in a recess provided by the housing 201, and may constitute most of the front side of the electronic device 101. Accordingly, the front surface of the electronic device 101 may include the display 230, and partial areas of the first housing 210 and the second housing 220, which are adjacent to the display 230. The rear surface of the electronic device 101 may include the first rear surface cover 280, a partial area of the first housing 210 adjacent to the first rear surface cover 280, the second rear surface cover 290, and a partial area of the second housing 220 adjacent to the second rear surface cover 290.

According to an embodiment, the display 230 may include a plurality of display areas spaced apart from each other. For example, the display 230 may include a first display area 231 disposed on the first housing 210, a second display area 232 disposed on the second housing 220, and a folding area 233. According to an embodiment, the first display area 231 and the second display area 232 may be rotatable about the folding axis A.

According to an embodiment, the display 230 may refer to a display that is at least partially deformable into a planar surface or a curved surface. For example, the display 230 may be a foldable or flexible display. According to an embodiment, the display 230 may include a folding area 233, a first display area 231 disposed on one side of the folding area 233 (e.g., the left side of the folding area 233 illustrated in FIG. 2), and a second display area 232 disposed on the other side of the folding area 233 (e.g., the right side of the folding area 233 illustrated in FIG. 2). However, the area division of the display 230 is exemplary, and the display 230 may be divided into a plurality of areas (e.g., four or more areas or two areas) depending on the structure or functions thereof. For example, in the embodiment illustrated in FIG. 2, the area of the display 230 may be divided by the folding area 233 or the folding axis (the axis A) extending parallel to the Y axis. However, in another embodiment, the area of the display 230 may be divided based on another folding area (e.g., a folding area parallel to the X axis) or another folding axis (e.g., a folding axis parallel to the X axis). According to an embodiment, the display 230 may be coupled to or disposed adjacent to a touch sensing circuit, a pressure sensor configured to measure touch intensity (pressure), and/or a digitizer (not illustrated) configured to detect a magnetic field-type stylus pen.

According to an embodiment, the first display area 231 and the second display area 232 may have generally symmetrical shapes about the folding area 233. According to an embodiment (not illustrated), unlike the first display area 231, the second display area 232 may include a notch cut due to the presence of the sensor area 224, but may have a shape substantially symmetrical to the first display area 231 in areas other than the sensor area. For example, the first display area 231 and the second display area 232 may include portions having mutually symmetrical shapes and portions having mutually asymmetrical shapes.

Hereinafter, the operations of the first housing 210 and the second housing 220 depending on the states of the electronic device 101 (e.g., a flat or unfolded state and a folded state) and respective areas of the display 230 will be described.

According to an embodiment, when the electronic device 101 is in the unfolded state (the flat state) (e.g., FIG. 2), the first housing 210 and the second housing 220 may be disposed to substantially form an angle of 180 degrees therebetween and to be oriented in the same direction. The surface of the first display area 231 and the surface of the second display area 232 of the display 230 may form 180 degrees therebetween and may be oriented in the same direction (e.g., the front direction of the electronic device). The folding area 233 may define the same plane as the first display area 231 and the second display area 232.

According to an embodiment, when the electronic device 101 is in the folded state (e.g., FIG. 3), the first housing 210 and the second housing 220 may be disposed to face each other. The surface of the first display area 231 and the surface of the second display area 232 of the display 230 may face each other while forming a narrow angle (e.g., between 0 degrees and 10 degrees) therebetween. When the electronic device 101 is in the folded state, at least a portion of the folding area 233 may be formed as a curved surface having a predetermined curvature.

According to an embodiment, when the electronic device 101 is in the intermediate state (not illustrated), the first housing 210 and the second housing 220 may be disposed to form a certain angle therebetween. The surface of the first display area 231 and the surface of the second display area 232 of the display 230 may form an angle greater than that in the folded state and smaller than that in the unfolded state. At least a portion of the folding area 233 may form a curved surface having a predetermined curvature, and the curvature in this case may be smaller than that in the folded state.

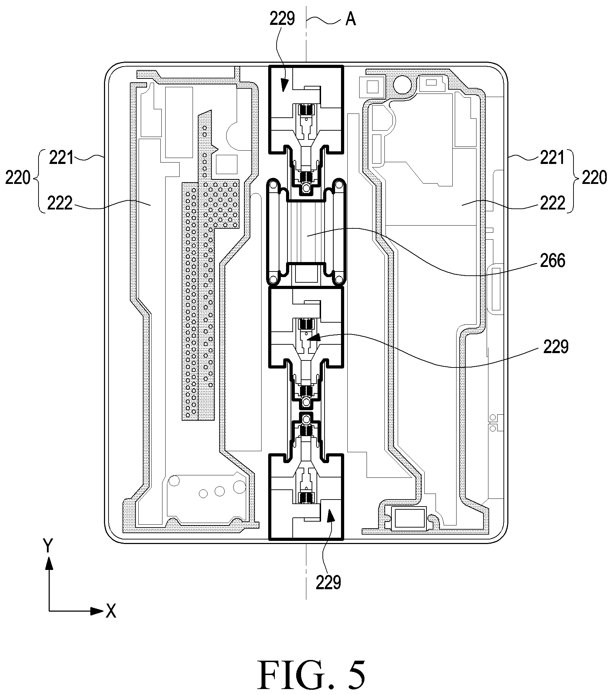

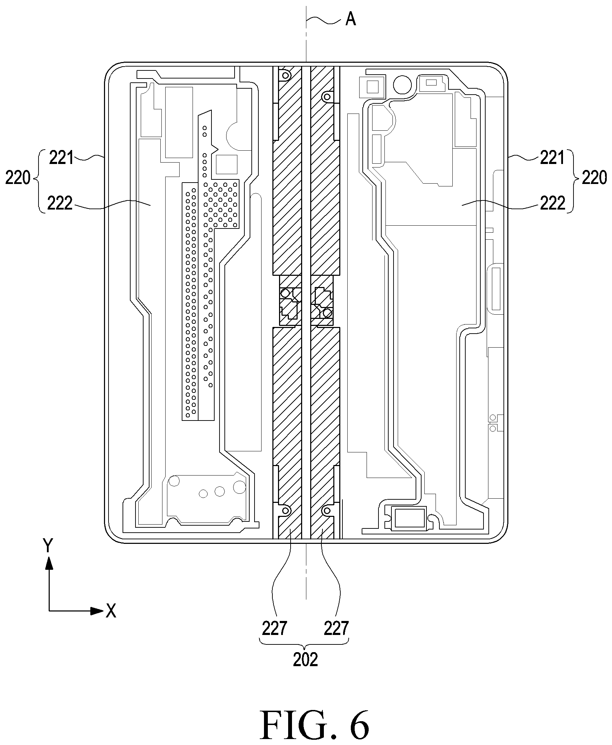

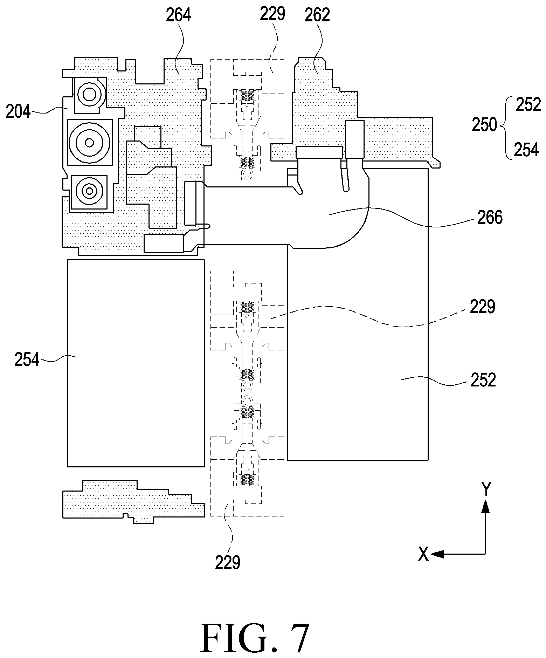

FIG. 4 is an exploded perspective view of an electronic device according to an embodiment of the disclosure. FIG. 5 is a view illustrating a state in which housings are coupled in an electronic device according to an embodiment of the disclosure. FIG. 6 is a view illustrating a state in which hinge plates are disposed in an electronic device according to an embodiment of the disclosure. FIG. 7 is a view illustrating an arrangement of one or more hinge modules and electronic components inside an electronic device according to an embodiment of the disclosure.

Referring to FIGS. 4 to 7, an electronic device 200 (e.g., the electronic device 101 of FIGS. 1 to 3) may include a housing 201, a display 230, a hinge assembly 202, a battery 250, and a board unit 260. For example, the housing 201 may include a first housing 210, a second housing 220, a first rear surface cover 280, and a second rear surface cover 290. In an embodiment, the housing 201 may be understood to include a hinge cover 240. The configuration of the first housing 210, the second housing 220, the hinge cover 240, the first rear surface cover 280, and the second rear surface cover 290 of FIG. 4 may be wholly or partly the same as the configuration of the first housing 210, the second housing 220, the hinge cover 240, the first rear surface cover 280, and the second rear surface cover 290 in FIG. 2 and/or FIG. 3.

According to an embodiment, the first housing 210 and the second housing 220 may be assembled to each other to be coupled to opposite sides of the hinge assembly 202. For example, the hinge assembly 202 may be disposed in a hinge area between the first housing 210 and the second housing 220 to rotatably couple the first housing 210 and the second housing 220. Here, the term "hinge area" may refer to a space in which the hinge assembly 202 is disposed, an area at least partially surrounded by the hinge cover 240, and/or a space between a folding area 233 of the display 230 and the hinge cover 240. In an embodiment, the hinge area may be understood as a space substantially corresponding to the folding area 233.

According to an embodiment, as illustrated in FIGS. 5 to 7, the hinge assembly 202 may include at least one hinge module 229 and a plurality of hinge plates 227. In the illustrated embodiment, three hinge modules 229 are sequentially arranged along the folding axis A direction, and a flexible printed circuit board 266 may be disposed to cross the folding axis A through an area between two hinge modules 229. As will be described below, by arranging or implementing a plurality of antennas or radiating conductors around the camera assembly 204 (e.g., the camera module 206 of FIG. 2 or FIG. 3), the degree of design freedom of the flexible printed circuit board 266 may be increased. For example, as a greater number of antennas are implemented in one of the plurality of housings 210 and 220 and are disposed in the same housing as a communication circuit (e.g., the communication module 190 of FIG. 1), a transmission line between the communication circuit and the antennas in wiring that crosses the folding axis A may be simplified.

Although not illustrated, the hinge module 229 may include a hinge portion that provides at least one folding axis A and an interlocking portion that interlocks the relative movements of the housings 210 and 220. For example, one or more housings 210 and 220 may be coupled to the hinge module 229 and may be rotatable relative to the hinge module 229 or the hinge cover 240. The interlocking portion may include, for example, a first gear configured to rotate on the hinge cover 240 as the first housing 210 rotates, and a second gear configured to rotate on the hinge cover 240 as the second housing 220 rotates. In an embodiment, when the first gear and the second gear are meshed, the first housing 210 and the second housing 220 may be configured to rotate in opposite directions relative to each other. For example, when the first housing 210 rotates in a clockwise direction on the hinge cover 240, the hinge assembly 202 (e.g., the interlocking portion of the hinge module 229) may rotate the second housing 220 in a counterclockwise direction on the hinge cover 240. In an embodiment, by further disposing a plurality of gears (e.g., one pair or two pairs) between the first gear and the second gear, rotations of the first housing 210 and the second housing 220 may be interlocked. The number of gears included in the hinge module 229 (e.g., the interlocking portion) may be appropriately selected according to design specifications of the electronic device, such as a size or a shape of an available arrangement space.

According to an embodiment, the hinge plate(s) 227 may be rotatably coupled to one of the housings 210 and 220. In an unfolded state of FIG. 2, the hinge plates 227 may be aligned to form a continuous plane and may support a portion of the display 230 (e.g., the folding area 233 of FIG. 2 or FIG. 4). In the folded state of FIG. 3, the hinge plates 227 may be disposed to be inclined relative to each other and may implement a space configured to accommodate the folding area 233 deformed into a curved shape. In an embodiment, when the hinge plates 227 provide a space configured to accommodate the folding area 233 while being inclined relative to each other, the folding area 233 may maintain a curved shape having a curvature within a predetermined range in a folded state. For example, in the folded state of FIG. 3, by having a curvature radius of a predetermined size, the folding area 233 may be protected from damage due to excessive folding, and surfaces of the first display area 231 and the second display area 232 may be arranged to form an angle of substantially 0 degrees.

According to an embodiment, the first housing 210 may include a first support area 212 (e.g., a first support member) configured to support components of the electronic device 200 (e.g., a first circuit board 262 and/or a first battery 252), and a first side wall 211 configured to surround at least a portion of the first support area 212. The first side wall 211 may include a first side surface (e.g., the first side surface 210c of FIG. 2) of the electronic device 200. According to an embodiment, the second housing 220 may include a second support area 222 configured to support components of the electronic device 200 (e.g., a second circuit board 264 and/or a second battery 254), and a second side wall 221 configured to surround at least a portion of the second support area 222. The second side wall 221 may include a second side surface (e.g., the second side surface 220c in FIG. 2) of the electronic device 200.

According to an embodiment, the first side wall 211 or the second side wall 221 may be understood as having a frame shape that at least partially surrounds a space between the front surface and the rear surface of the electronic device 200 (e.g., the first housing 210 or the second housing 220). In an embodiment, the support areas 212 and 222 may each extend from a corresponding one of the side walls 211 and 221. For example, although the support areas 212 and 222 and the side walls 211 and 221 are described separately for convenience of description, the embodiment(s) of the disclosure is not limited thereto, and the support area 212 or 222 and the side wall 211 or 221 may be implemented as a single body. In an embodiment, the support area 212 or 222 and the side wall 211 or 221 may be implemented by a combination of an insulating material and an electrically conductive material. In this case, the housings 210 and 220 may be implemented such that the support area 212 or 222 and the side wall 211 or 221 are integrally formed through an insert injection molding process and/or a computer numerical control (CNC) machining process. As will be described below with reference to embodiments described later, when including an electrically conductive material, portions of the support areas 212 and 222 and the side walls 211 and 221 may function as one or more antennas or radiating conductors.

According to an embodiment, as described above, a portion of at least one of the housings 210 and 220 in the electronic device 200 may function as an antenna. In an embodiment, a portion functioning as an antenna of the electronic device 200 may implement a side surface of at least one of the housings 210 and 220. In an embodiment, the portion functioning as an antenna of the electronic device 200 may be disposed adjacent to a side surface of at least one of the housings 210 and 220 and/or to be oriented in a direction intersecting a Z-axis. For example, the portion functioning as an antenna of the electronic device 200 may be implemented by a portion of the housings 210 and 220, or may be manufactured as a separate component from the housings 210 and 220 and disposed adjacent to an edge of the housings 210 and 220. In an embodiment, from the description "the portion functioning as an antenna of the electronic device 200 is implemented by a portion of the housings 210 and 220" may be understood to include an example in which the portion functioning as an antenna is disposed to form a side surface of at least one of the housings 210 and 220.

According to an embodiment, although not illustrated, the first housing 210 may include a first waterproofing member disposed in the first support area 212, and/or the second housing 220 may include a second waterproofing member disposed in the second support area 222. The first waterproofing member and/or the second waterproofing member may be disposed in a gap between the display 230 and one or more support areas 212 and 222 to suppress inflow of moisture or foreign substances from the outside into an interior of the first housing 210 and/or the second housing 220.

According to an embodiment, the display 230 may include a first display area 231, a second display area 232, and/or a folding area 233. The configurations of the first display area 231, the second display area 232, and the folding area 233 of FIG. 3 may be the same as all or part of the configurations of the first display area 231, the second display area 232, and the folding area 233 of FIG. 2.

According to an embodiment, the electronic device 200 may further include a sub-display 234. In an embodiment, the sub-display 234 may display a screen in a direction different from that of the display areas 231 and 232. For example, the sub-display 234 may output a screen in a direction opposite to the first display area 231. According to an embodiment, the sub-display 234 may be disposed on the first rear surface cover 280.

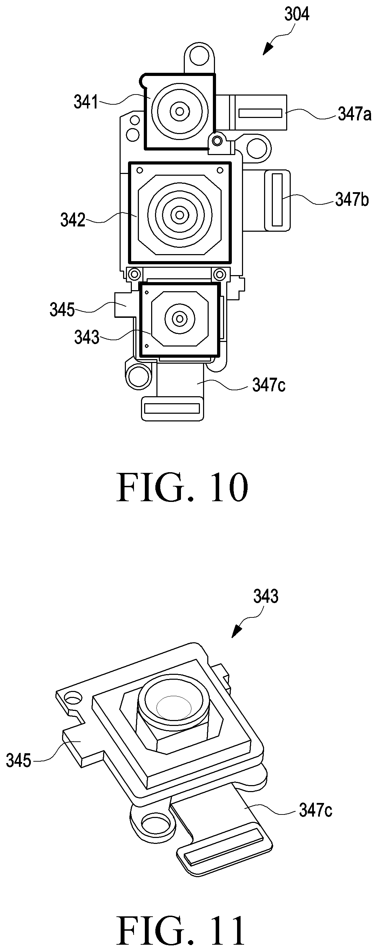

According to an embodiment, the electronic device 200 may include a camera assembly 204 in which a plurality of cameras are combined (e.g., the camera module 206 of FIG. 2 or FIG. 3). Although not illustrated, the electronic device 200 may further include a camera configured to image an object through a portion of the display 230 (e.g., the first display area 231 or the second display area 232), or a camera configured to image an object through a portion of the sub-display 234. As will be described below, the camera assembly 204 may include a plurality of cameras having different angles of view. For example, the camera assembly 204 may include a camera having an angle of view of about 100 degrees or more (e.g., the first camera 341 of FIG. 10), a camera having an angle of view of about 65 degrees to about 85 degrees (e.g., the second camera 342 of FIG. 10), and/or a camera having an angle of view of about 15 degrees to about 40 degrees (e.g., the third camera 343 of FIG. 10). In an embodiment, an additional camera having an angle of view different from the above-described ranges (e.g., about 40 degrees to about 60 degrees) may be included in the camera assembly.

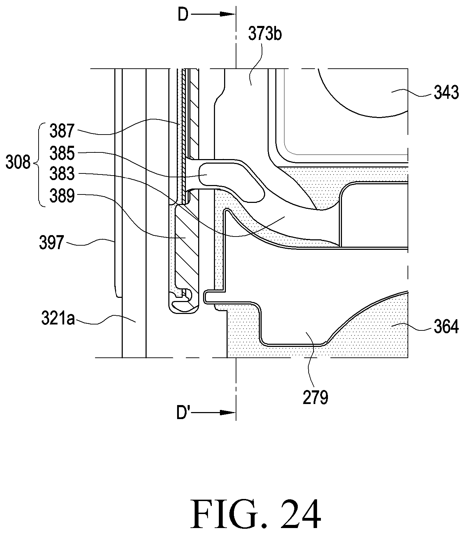

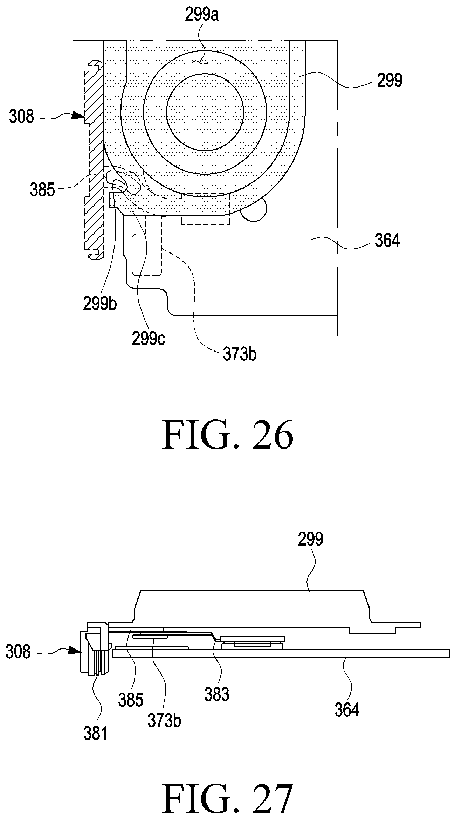

According to an embodiment, the electronic device 200 and/or the second rear surface cover 290 may include a cover plate 299 disposed to correspond to the camera assembly 204. The cover plate 299 may, for example, provide an optical path (e.g., a through hole) corresponding to the camera assembly 204 while harmonizing the optical path with the exterior of the electronic device 200. To impart an aesthetic sensation to the exterior of the electronic device 200 or to achieve a harmonious exterior design, the cover plate 299 may include a metal material. For example, the cover plate 299 may be made of a metal material or finished (e.g., printed, deposited, coated, or plated) with a metal material. In an embodiment, the cover plate 299 may be understood as a portion of the second rear surface cover 290. A portion (e.g., an edge) of the cover plate may be disposed inside the second rear surface cover 290 and another portion may be exposed to the outside. As will be described below, when the cover plate 299 includes a metal material, for example, an electrically conductive material, electromagnetic coupling may be suppressed by including a notch portion in at least a portion of an area overlapping transmission wiring (the flexible printed circuit boards 373b and 383 of FIG. 24 or FIG. 26).

According to an embodiment, the battery 250 may include a first battery 252 disposed in the first housing 210 and a second battery 254 disposed in the second housing 220. According to an embodiment, the first battery 252 may be connected to a first circuit board 262, and the second battery 254 may be connected to a second circuit board 264. According to an embodiment, the battery 250 may supply power to at least one component of the electronic device 200. According to an embodiment, the battery 250 may include, for example, a non-rechargeable primary cell, a rechargeable secondary cell, or a fuel cell.

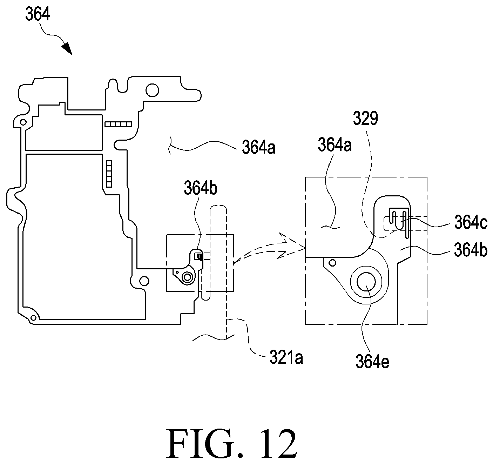

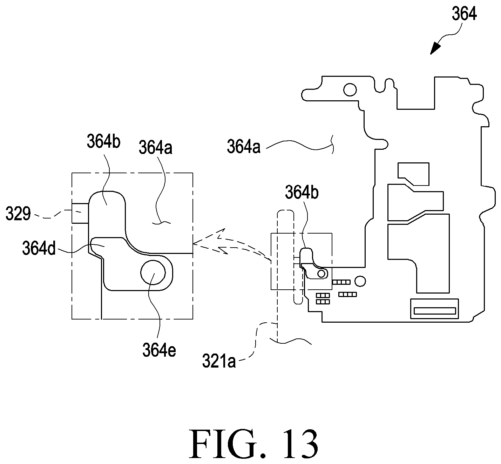

According to an embodiment, the board unit 260 may include the first circuit board 262 disposed within the first housing 210 and the second circuit board 264 disposed within the second housing 220. According to an embodiment, the first circuit board 262 and the second circuit board 264 may be electrically connected by at least one flexible printed circuit board 266. According to an embodiment, at least a portion of the flexible printed circuit board 266 may be disposed to cross a hinge area or a hinge structure (e.g., a hinge assembly 202). According to an embodiment, the first circuit board 262 and the second circuit board 264 may be disposed inside a space defined by the first housing 210, the second housing 220, the first rear surface cover 280, and the second rear surface cover 290. Components for implementing various functions of the electronic device 200 may be mounted on the first circuit board 262 and the second circuit board 264. As will be described below, one of the first circuit board 262 and the second circuit board 264 may provide an opening area (e.g., the opening area 364a of FIG. 12 or FIG. 13) configured to accommodate the camera assembly 204.

According to an embodiment, the electronic device 200 may include speakers 208a and 208b. According to an embodiment, the speakers 208a and 208b may convert electrical signals into sound. According to an embodiment, the speakers 208a and 208b may be disposed inside the space defined by the first housing 210, the second housing 220, the first rear surface cover 280, and the second rear surface cover 290. According to an embodiment, the speakers 208a and 208b may include an upper speaker 208a located at an upper portion (+Y direction) of the electronic device 200 and a lower speaker 208b located at a lower portion (-Y direction) of the electronic device 200. In the disclosure, the speakers 208a and 208b are illustrated as being located within one housing (e.g., the first housing 210 in FIG. 4), but this is an optional structure. For example, the speakers 208a and 208b may be located within at least one of the first housing 210 or the second housing 220. The configuration of the speakers 208a and 208b in FIG. 4 may be wholly or partially the same as the configuration of the sound output module 155 in FIG. 1.

According to an embodiment, the electronic device 200 may include a rear member 270 (or a rear case). According to an embodiment, the rear member 270 may be disposed within the housing 201 (e.g., the second housing 220). According to an embodiment, the rear member 270 may accommodate at least one antenna 275. In an embodiment, the rear member 270 may function as a structure configured to have the antenna 275 disposed thereon and may function as a structure configured to support or protect one of the circuit boards 262 and 264. For example, a portion of the rear member 270 indicated by reference numeral '279' may support a portion of a circuit board 262 or 264.

According to an embodiment, the electronic device 200 may include an antenna 275. The antennas 275a and 275b may include, for example, an ultra wide band (UWB) antenna 275a, a near field communication (NFC) antenna, a wireless charging antenna, and/or a magnetic secure transmission (MST) antenna 275b. The antenna 275 may, for example, perform short-range communication with an external device or wirelessly transmit and receive power required for charging.

In an embodiment, an antenna structure may be provided by portions of the housing 201 or a combination thereof. For example, the antenna 275 may include a communication antenna 275c that is at least partially exposed to the outside of the electronic device 200 and forms at least a portion of the exterior of the electronic device 200. The communication antenna 275c may be used for communication with an external electronic device (e.g., Wi-Fi). For example, the communication antenna 275c may be located at an upper portion 271a or a lower portion 271b of the rear member 270. In addition, the electronic device 200 may further include an additional antenna disposed adjacent to a portion of the side walls 211 and 221 or adjacent to an electronic component such as the camera assembly 204, which will be described in detail through embodiments described below.

In the following detailed description, a configuration in which a pair of housings (or referred to as a "housing structure") is rotatably coupled by a hinge structure (or referred to as a "hinge assembly 202") may be described as an example. However, it should be noted that an electronic device according to various embodiments disclosed herein is not limited by the embodiments. For example, an electronic device according to the embodiment(s) of the disclosure may include three or more housings, and the "pair of housings" described in the embodiments below may refer to "two housings that are rotatably coupled to each other among the three or more housings." In an embodiment, all components of the electronic device 101 of FIG. 1 may be included in one of the first housing 210 or the second housing 220 described above, and in this case, the one of the first housing 210 or the second housing 220 itself may be understood as an embodiment of the electronic device. For example, it should be noted that an electronic device according to the embodiment(s) of the disclosure is not limited by the number of housings or by a coupling structure implemented between a plurality of housings.

In the embodiments described below, components that are duplicated or components that may be readily understood through preceding embodiments may be assigned the same reference numerals or omitted, and detailed descriptions thereof may be omitted. Even when reference numerals are assigned in the drawings but are not mentioned in the detailed description referring to the drawings, a person ordinarily skilled in the art may readily understand such components through the overall detailed description of the disclosure.

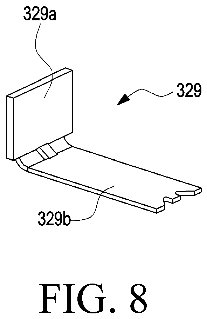

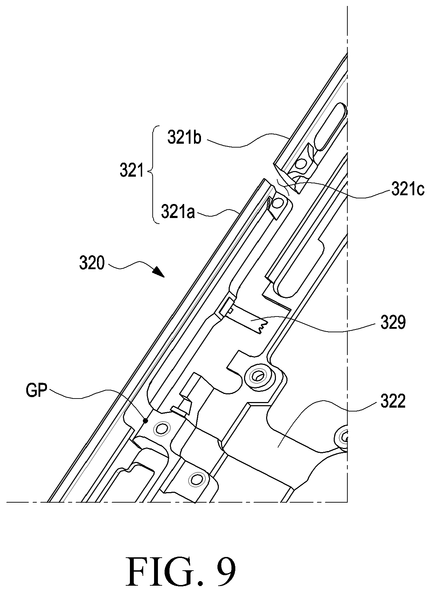

FIG. 8 is a perspective view illustrating a contact piece of an electronic device according to an embodiment of the disclosure. FIG. 9 is a perspective view illustrating a state in which the contact piece is disposed in an electronic device according to an embodiment of the disclosure.

Referring further to FIGS. 8 and 9, the electronic device 200 may include at least one contact piece 329. The contact piece 329 may be, for example, a plate or a leaf spring bent into an L shape, and may be disposed in a first portion 321a of a side wall 321 (e.g., the second side wall 221 of FIG. 4). The first portion 321a of the side wall 321 may, for example, form a portion of a frame shape and may include at least partially an electrically conductive material. The contact piece 329 may include a fixing portion 329a disposed on an inner surface of the first portion 321a, and a contact portion 329b bent at a predetermined angle with respect to the fixing portion 329a. In a state in which the fixing portion 329a is disposed on the inner surface of the first portion 321a, the contact portion 329b may be understood as extending from the inner surface of the first portion 321a toward an inner side of the housing 320 (e.g., the second housing 220 of FIG. 4). The fixing portion 329a may be fixed to the inner surface of the first portion 321a by welding or soldering, and/or by an electrically conductive adhesive or an electrically conductive tape.

According to an embodiment, the first portion 321a of the side wall 321 may be electrically connected to a communication circuit (e.g., the communication module 190 of FIG. 1) through the contact piece 329. For example, the electronic device 200, a processor (e.g., the processor 120 of FIG. 1), and/or a communication module (e.g., the communication module 190 of FIG. 1) may perform wireless communication using the first portion 321a. In an embodiment, the first portion 321a may function as a radiating conductor (e.g., an antenna) configured to perform wireless communication in at least one of a frequency band of about 1.8 GHz, a frequency band of about 2.4 GHz, and/or a frequency band of about 3.5 GHz. In an embodiment, when the first portion 321a functions as a radiating conductor, the contact piece 329 may be provided as a feeding point, and a portion indicated by "GP" in FIG. 9 may be provided as a short-circuit point or a ground point. For example, the first portion 321a may be implemented as an inverted-F antenna.

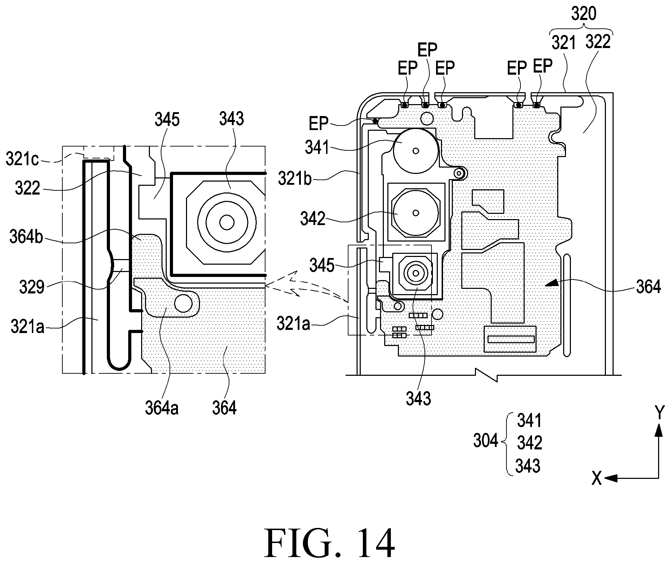

According to an embodiment, the side wall 321 may include a second portion 321b adjacent to the first portion 321a and electrically insulated from the first portion 321a. In an embodiment, the second portion 321b (e.g., an outer surface) may be disposed to form a continuous curved surface or a continuous planar surface with the first portion 321a when viewed from the outside of the electronic device 200. Although not illustrated in the drawings of FIG. 9, a portion indicated by "321c" may exemplify an insulating structure (e.g., the insulating structure 321c of FIG. 14, FIG. 16, and/or FIG. 17). For example, the first portion 321a and the second portion 321b may be electrically insulated from each other while being mechanically connected or coupled to each other by the insulating structure 321c. When including an electrically conductive material (e.g., metal) and an insulating structure 321c, the housing 320 (e.g., the side wall 321 and/or a support area 322) may be manufactured through an insert injection molding process. For example, the insulating structure 321c may be molded in a state in which a previously manufactured electrically conductive portion is placed in a mold, and after molding, an additional process such as computer numerical control machining may be performed as needed to manufacture the housing 321 having a desired design shape.

FIG. 10 is a view illustrating a camera assembly of an electronic device according to an embodiment of the disclosure. FIG. 11 is a perspective view illustrating a third camera among the camera assembly of FIG. 10 in an electronic device according to an embodiment of the disclosure.

Referring to FIGS. 10 and 11, a camera assembly 304 (e.g., the camera assembly 204 of FIG. 4 or FIG. 7) may include a plurality of cameras 341, 342, and 343. For example, the camera assembly 304 may include a first camera 341 configured to provide an ultra-wide-angle function, a second camera 342 configured to provide a wide-angle function, and/or a third camera 343 configured to provide a telephoto function. Here, it should be noted that optical performances (e.g., an angle of view or a focal length) such as "ultra-wide-angle," "wide-angle," and/or "telephoto" are not limited to those defined by specifications of the cameras 341, 342, and 343. For example, in the embodiment(s) of the disclosure, the optical performances of the cameras 341, 342, and 343 may be defined based on relative comparisons of angles of view or focal lengths of the cameras 341, 342, and 343 included in the camera assembly 304.

According to an embodiment, the cameras 341, 342, and 343 may be arranged along a length direction of the electronic device 200 or the housing 320 (e.g., the Y-axis direction of FIG. 4). In an embodiment, the cameras 341, 342, and 343 may be arranged along the width direction of the electronic device 200 (e.g., the X-axis direction of FIG. 4), or may be arranged along a closed-loop trajectory. For example, the number and arrangement of cameras 341, 342, and 343 do not limit the embodiment(s) of the disclosure and may be variously changed according to specifications of the electronic device 200. In an embodiment, the cameras 341, 342, and 343 may be electrically connected to a circuit board (e.g., the second circuit board 264 of FIG. 4 or the circuit board 364 of FIG. 12) by including one or more wiring boards 347a, 347b, and 347c.

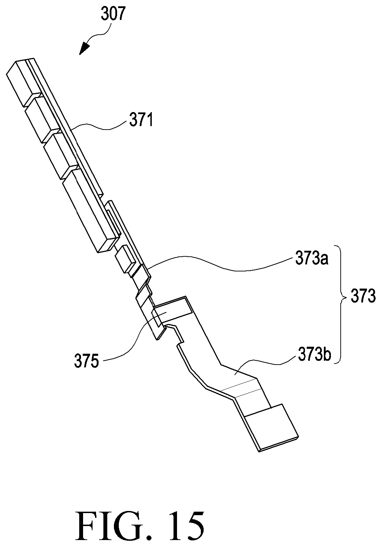

According to an embodiment, the electronic device 200 and/or the camera assembly 304 may further include at least one support protrusion 345. In an embodiment, when another electronic component (e.g., the antenna module 307 of FIG. 15) is disposed adjacent to the camera assembly 304, the support protrusion 345 may provide a structure for supporting the other electronic component, or may provide an alignment structure for wiring of the other electronic component (e.g., the first flexible printed circuit board 373 of FIG. 15). In the illustrated embodiment, the support protrusion 345 may be understood as protruding from one side of the third camera 343. However, the embodiment(s) of the disclosure is not limited thereto, and an additional support protrusion may be provided on the first camera 341 or the second camera 342, and/or when the support protrusion are provided on the first camera 341 or the second camera 342, the support protrusion 345 of the third camera 343 may be omitted. For example, the support protrusion 345 may be variously implemented according to a position of an electronic component disposed adjacent to the camera assembly 304 or a wiring path.

FIG. 12 is a first view illustrating a circuit board of an electronic device according to an embodiment of the disclosure. FIG. 13 is a second view illustrating the circuit board of the electronic device according to an embodiment of the disclosure.

Referring to FIGS. 12 and 13, a circuit board 364 (e.g., the second circuit board 264 of FIG. 4) may provide an opening area 364a at one side edge thereof. Although not assigned with reference numerals, at least one surface of the circuit board 364 may have one or more electrical/electronic components, such as an integrated circuit chip, and/or various connectors disposed thereon. At least one connector may provide a connection structure with an electronic component such as the camera assembly 304. The opening area 364a may, for example, provide a space configured to accommodate at least a portion of the camera assembly 304. In an embodiment, when the circuit board 364 is aligned to overlap the camera assembly 304 in the thickness direction (e.g., the Z-axis direction of FIG. 4) between a front surface (e.g., the second front surface 220a of FIG. 2) and a rear surface (e.g., the second rear surface 220b of FIG. 2) of the housing 320, the thickness of the electronic device 200 may increase. The opening area 364a provides a space or area in which the camera assembly 304 may be disposed, and thus may reduce an increase in the thickness of the electronic device 200 in arrangement of the camera assembly 304 and the circuit board 364. For example, the circuit board 364 may be disposed between the front surface and the rear surface of the housing 320 so as to at least partially not overlap the camera assembly 304 in the thickness direction.

According to an embodiment, the circuit board 364 may form a portion of the opening area 364a or may include an extension portion 364b surrounding at least a portion of the opening area 364a. As will be described below with reference to at least FIG. 14, the extension portion 364b may be disposed, for example, between the first portion 321a and the camera assembly 304 within the housing 320. In an embodiment, the contact piece 329 (e.g., the contact portion 329b) may be disposed to at least partially face the extension portion 364b. For example, the extension portion may be disposed between a side wall (e.g., the first portion) and the camera assembly in the width direction of the electronic device 200 (e.g., the X-axis direction of FIG. 4), and may be disposed to face the contact piece in the thickness direction of the electronic device 200 (e.g., the Z-axis direction of FIG. 4). In an embodiment, the contact piece 329 may be understood as being disposed between the front surface of the housing 320 and the extension portion 364b in the thickness direction of the electronic device 200. In an embodiment, the extension portion 364b may be utilized as a portion that electrically connects the contact piece 329 and/or the side wall 321 (e.g., the first portion 321a) to the circuit board 364.

According to an embodiment, in electrically connecting the first portion 321a and/or the contact piece 329 to the circuit board 364, the electronic device 200 and/or the circuit board 364 may further include a leaf-spring-type contact terminal 364c disposed on one surface of the circuit board 364 (e.g., the extension portion 364b). In an embodiment, when the first portion 321a functions as a radiating conductor, the contact terminal 364c may be electrically connected to the circuit board 364 by being in direct contact with the contact piece 329 (e.g., the contact portion 329b), such that the first portion 321a and/or the contact piece 329b may be electrically connected to the circuit board 364 through the contact terminal 364c. For example, the first portion 321a functioning as a radiating conductor may receive a feeding signal via the contact piece 329 and/or the contact terminal 364c. In an embodiment, the contact portion 329b may be manufactured to have a curved shape to be in direct contact with the circuit board 364 (e.g., the extension portion 364b). In this case, the contact terminal 364c may be replaced with a flat pad rather than a leaf-spring structure.

According to an embodiment, in order to stably maintain a contact state between the contact piece 329 and the contact terminal 364c, the contact piece 329 or the contact terminal 364c may have a leaf-spring structure. For example, when the circuit board 364 is disposed on the housing 320, the contact piece 329 and the contact terminal 364c may come into contact with each other and may be partially deformed or partially displaced while storing elastic force. In an embodiment, the extension portion 364b may have a sufficiently small width to be disposed in a narrow gap between the first portion 321a and the camera assembly 304. In this case, the elastic force stored in the contact piece 329 and the contact terminal 364c may deform or damage the extension portion. For example, when the extension portion 364b is deformed, it may be difficult to stably maintain the electrical connection between the contact piece 329 and the contact terminal 364c, and durability of the extension portion 364b may be degraded.

According to an embodiment, the electronic device 200 and/or the circuit board 364 may further include a support plate 364d so as to suppress deformation of the extension portion 364b and stably maintain the connection state between the contact piece 329 and the contact terminal 364c. In an embodiment, the support plate 364d may be made of a metal material such as stainless steel and may be disposed on the other surface of the circuit board 364. In an embodiment, the support plate 364d may be understood as being disposed, at least in part, on the other surface of the extension portion 364b. For example, even when elastic force is applied to the extension portion 364b by the contact piece 329 and the contact terminal 364c, deformation or damage of the extension portion 364b may be suppressed by the support plate 364d supporting the extension portion 364b.

According to an embodiment, the electronic device 200 and/or the circuit board 364 may further include a fastening hole 364e penetrating the circuit board 364 and/or the support plate 364d in an area adjacent to the extension portion 364b. For example, when fixing the circuit board 364 within the housing 320 (e.g., the support area 322), a fastening member such as a screw may fix the circuit board 364 and the support plate 364d to the support area 322 through the fastening hole 364e. The fastening force provided by the fastening member may further suppress deformation of the extension portion 364b and/or the support plate 364d due to elastic force.

FIG. 14 is a view illustrating a state in which the camera assembly of FIG. 11 and the circuit board of FIG. 13 are disposed in a housing of an electronic device according to an embodiment of the disclosure.

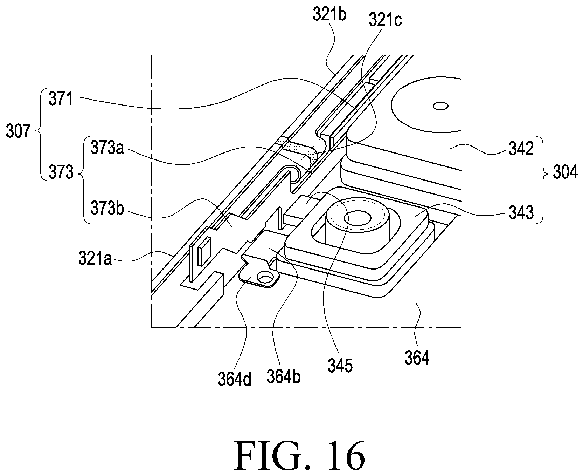

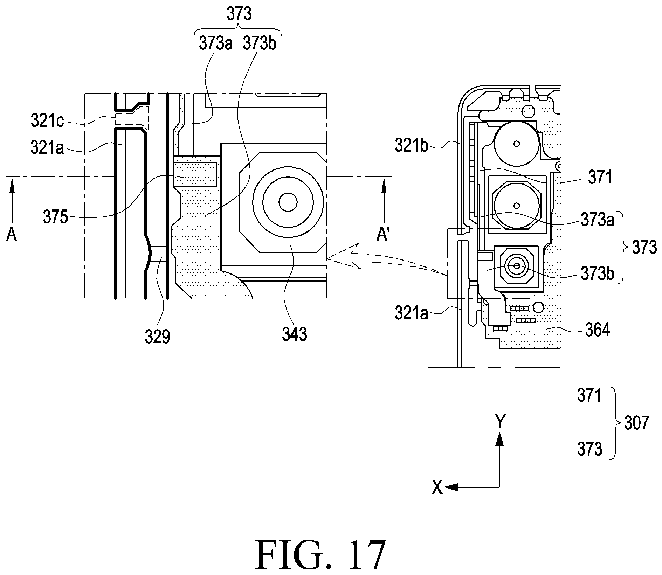

Referring further to FIG. 14, within a space at least partially surrounded by a side wall 321, the camera assembly 304 may be disposed adjacent to a portion of the side wall 321. For example, the camera assembly 304 may be disposed on a support area 322 of the housing 320 adjacent to a first portion 321a and/or a second portion 321b of the side wall 321. The support protrusion 345 of the camera assembly 304 may, for example, be disposed in a form protruding toward the side wall 321 (e.g., the first portion 321a). For example, the support protrusion 345 may be understood as protruding from one side surface of the third camera 343 toward the first portion 321. As will be described below with reference to at least FIGS. 16 to 18, a first flexible printed circuit board 373 extending from an antenna module (e.g., the antenna module 307 of FIG. 15 or FIG. 17) may be partially disposed between the side wall 321 and the support protrusion 345, and may be bent to surround at least a portion of the support protrusion 345.

According to an embodiment, the circuit board 364 may be disposed on the support area 322 (or on an inner side of the side wall 321) in a state in which the extension portion 364b is positioned in an area between the camera assembly 304 and the first portion 321a. For example, between the camera assembly 304 and the first portion 321a, a contact terminal 364c (e.g., the contact terminal 364c of FIG. 12) of the circuit board 364 may be in contact with the contact piece 329, such that the side wall 321 (e.g., the first portion 321a) may be electrically connected to the extension portion 364b and/or the circuit board 364 sequentially via the contact piece 329 and the contact terminal 364c.

According to an embodiment, the second portion 321b of the side wall 321 may be electrically connected to the circuit board 364 to function as an antenna (e.g., a radiating conductor). For example, the processor 120 and/or the communication module 190 of FIG. 1 may be configured to perform wireless communication using the second portion 321b in a frequency band different from that of the first portion 321a (e.g., about an 850 MHz frequency band and/or about a 900 MHz frequency band). In an embodiment, in addition to the first portion 321a and the second portion 321b, one or more other electrically conductive portions of the side wall 321 may be electrically connected to the circuit board 364 to perform wireless communication in respective different frequency bands. In an embodiment, the electrically conductive portions may be mechanically coupled while being electrically insulated from each other by an insulating structure (e.g., the insulating structure 321c of FIG. 14, FIG. 16, and/or FIG. 17). In FIG. 14, one or more points indicated by reference numeral EP may exemplify points at which one or more electrically conductive portions forming the side wall 321 are electrically connected to the circuit board 364 (e.g., feeding points or ground points).

FIG. 15 is a perspective view illustrating an antenna module of an electronic device according to an embodiment of the disclosure.

Referring to FIG. 15, an antenna module 307 may include an antenna substrate 371 and a first flexible printed circuit board 373 extending from the antenna substrate 371. In an embodiment, the first flexible printed circuit board 373 may be understood as being a component distinguished from the antenna module 307. In an embodiment, the antenna substrate 371 and the first flexible printed circuit board 373 may be implemented substantially as a single substrate, and in this case, the first flexible printed circuit board 373 may be manufactured to be more flexible or softer than the antenna substrate 371. The antenna module 307 may be configured, for example, to perform millimeter-wave (mmWave) communication in a frequency band of several tens of gigahertz or higher. For example, a plurality of radiating patches implemented in the form of printed circuit patterns may be provided on one surface of the antenna substrate 371, and the electronic device 200 may perform wireless communication using the antenna module 307 in a direction in which a surface on which the radiating patches are arranged is oriented. It should be noted that the illustrated embodiment exemplifies a structure in which a protective molding is provided on one surface of the antenna substrate 371 so as to conceal the radiating patches.

According to an embodiment, the first flexible printed circuit board 373 may be disposed inside the electronic device 200 and/or the housing 320 in a state of being bent at least once. The first flexible printed circuit board 373 may be described as being divided into a first alignment portion 373a between the antenna substrate 371 and the bent portion, and a second alignment portion 373b extending from the first alignment portion 373a. According to an embodiment, the first flexible printed circuit board 373 illustrated in FIG. 15 is exemplified as being assembled on the housing 320, and in an initial manufacturing state, the first flexible printed circuit board 373 may be substantially parallel to the antenna substrate 371. After being bent, the second alignment portion 373b may be disposed to be inclined or substantially perpendicular with respect to the antenna substrate 371 and/or with respect to the first alignment portion 373a. In an embodiment, the first flexible printed circuit board 373 may be electrically connected, at an end of the second alignment portion 373b, to a circuit board (e.g., the second circuit board 264 of FIG. 4 or the circuit board 364 of FIG. 17).

According to an embodiment, the electronic device 200 and/or the antenna module 307 may further include a first dummy member 375 disposed at a bent portion of the first flexible printed circuit board 373. The first dummy member 375 may be made of an elastic material, a synthetic resin, and/or a metal material, and may maintain the shape of the bent portion in a designed shape. For example, when the first flexible printed circuit board 373 has elasticity, the first flexible printed circuit board 373 may have a tendency to restore to an initially manufactured shape when disposed in the bent shape, and the first dummy member 375 may suppress restoring force of the first flexible printed circuit board 373 so as to force the first flexible printed circuit board 373 to be maintained in the bent shape.

According to an embodiment, a distance between the first flexible printed circuit board 373 and surrounding components (e.g., the side wall 321, the camera assembly 304, and/or the cover plate 299 of FIG. 26) may vary depending on the shape of the first flexible printed circuit board 373. When the first flexible printed circuit board 373 is configured to transmit wireless communication signals, such variations in distance may cause variations in wireless communication performance among different electronic devices having substantially the same design specifications. In an embodiment, the first dummy member 375 may maintain the first flexible printed circuit board 373 in a designed shape at a bent portion, thereby maintaining a constant distance from surrounding components. For example, by maintaining a shape of the first flexible printed circuit board 373 or a distance from surrounding components to be constant, the first dummy member 375 may suppress variations in wireless communication performance.

A configuration in which the antenna module 307 is disposed on the housing 320 will be further described with reference to FIGS. 16 to 18.

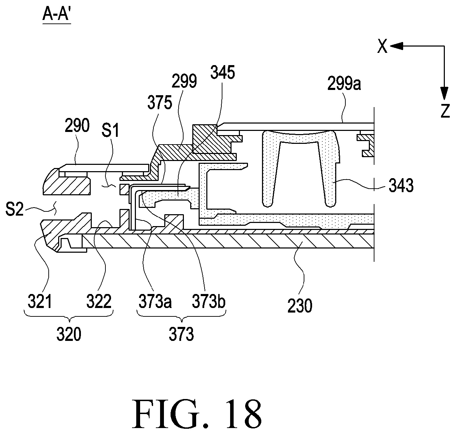

FIG. 16 is a perspective view illustrating a process in which the antenna module of FIG. 15 is disposed in the housing of the electronic device according to an embodiment of the disclosure. FIG. 17 is a view illustrating a state in which the antenna module of FIG. 15 is disposed in the housing of the electronic device according to an embodiment of the disclosure. FIG. 18 is a view illustrating a portion of the electronic device according to an embodiment of the disclosure, taken along line A-A' of FIG. 17.

Referring further to FIGS. 16 to 18, the antenna module 307 (e.g., the antenna substrate 371) may be disposed between the side wall 321 (e.g., the second portion 321b) and the camera assembly 304 such that the surface on which radiating patches are arranged faces the second portion 321b. In an embodiment, the first flexible printed circuit board 373 may extend from the antenna substrate 371 and may be disposed, at least in part, between the second portion 321b and the camera assembly 304 and/or between the first portion 321a and the camera assembly 304. In an embodiment, one end of the first flexible printed circuit board 373 (e.g., the second alignment portion 373b) may be electrically (or mechanically) connected to the circuit board 364 at one side of the third camera 343. For example, the first flexible printed circuit board 373 may transmit wireless communication signals from a communication circuit (e.g., the communication module 190 of FIG. 1) disposed on the circuit board 364 to the antenna substrate 371. In an embodiment, wireless communication signals received through the antenna substrate 371 may be provided to the circuit board 364 through the first flexible printed circuit board 373.

According to an embodiment, in the Y-axis direction, the support protrusion 345 may be disposed between the contact piece 329 (or the contact terminal 364c of FIG. 12) and the antenna substrate 371, and a bent portion of the first flexible printed circuit board 373 (e.g., the first dummy member 375) may be disposed to surround at least a portion of the support protrusion 345. For example, the bent portion of the first flexible printed circuit board 373 may be disposed adjacent to (or substantially in contact with) two areas of a surface of the support protrusion 345 that are inclined relative to each other or are substantially perpendicular to each other. In an embodiment, as illustrated in FIG. 16, a portion of the first flexible printed circuit board 373 (e.g., the first alignment portion 373a) may be disposed between the camera assembly 304 and the side wall 321 (e.g., the first portion 321a and/or the second portion 321b) in a state of being parallel to the antenna substrate 371. For example, between the bent portion and the antenna substrate 371, the first alignment portion 373a may be aligned together with the antenna substrate 371 in a direction facing the side wall 321.

According to an embodiment, from the bent portion (e.g., the first dummy member 375) to an end connected to the circuit board 364, another portion of the first flexible printed circuit board 373 (e.g., the second alignment portion 373b) may be bent relative to the first alignment portion 373a so as to be disposed to face a direction different from that of the first alignment portion 373a. For example, when the first alignment portion 373a is disposed to face the side wall 321, the second alignment portion 373b may be understood as being disposed to face substantially a front surface (e.g., the second front surface 220a of FIG. 2) or a rear surface (e.g., the second rear surface 220b of FIG. 2) of the electronic device 200. In an embodiment, the second alignment portion 373b may be disposed between the camera assembly 304 and the first portion 321a and/or between the camera assembly 304 and the second portion 321b.

According to an embodiment, between the side wall 321 and the camera assembly 304, the first flexible printed circuit board 373 may be disposed to cross an area in which the contact piece 329 and/or the contact terminal 364c is disposed. When the contact piece 329, the contact terminal 364c, and/or the first flexible printed circuit board 373 are disposed adjacent to each other while functioning as transmission lines for wireless communication signals, electromagnetic interference may occur. Electromagnetic interference generated between the transmission lines may degrade the efficiency of wireless communication or distort wireless communication signals. As described above, by being bent at least once, the first flexible printed circuit board 373 may be allowed to be disposed in a confined space while being disposed at a sufficient distance to suppress electromagnetic interference. Here, the description "a sufficient distance to suppress electromagnetic interference while being allowed to be in a confined space" may refer to a distance from the contact piece 329 or the contact terminal 364c, and may be a distance permitted by design specifications of the electronic device 200 or the housing 320.

According to an embodiment, the support protrusion 345 and/or the bent portion of the first flexible printed circuit board 373 may be disposed in an area between the contact piece 329 and the antenna substrate 371. For example, a portion of the first flexible printed circuit board 373 that crosses an area in which the contact piece 329 or the contact terminal 364c of FIG. 12 is disposed may substantially correspond to the second alignment portion 373b. According to an embodiment, the second alignment portion 373b may be understood as being disposed to face the contact piece 329 (or the contact terminal 364c) with the circuit board 364 (e.g., the extension portion 364b) interposed therebetween. In an embodiment, when the first alignment portion 373a is disposed so as to cross an area in which the contact piece 329 or the contact terminal 364c is disposed, the first flexible printed circuit board 373 may be disposed substantially close to the contact terminal 364c, thereby causing electromagnetic interference. In the embodiment(s) of the disclosure, an arrangement of the contact terminal 364c, the support protrusion 345, and/or the bent portion of the first flexible printed circuit board 373 may suppress electromagnetic interference by sufficiently securing a distance between the contact terminal 364c and the first flexible printed circuit board 373 (and/or a distance between the contact piece 329 and the first flexible printed circuit board 373) within a range permitted by an internal space of the electronic device 200. The distance between the contact terminal 364c and the first flexible printed circuit board 373 may be understood as being measured along the Y-axis direction from the contact terminal 364c to the first alignment portion 373a in the structure illustrated in FIG. 17, and as being measured along the Z-axis direction from the contact terminal 364c to the second alignment portion 373b in the structure illustrated in FIG. 18.

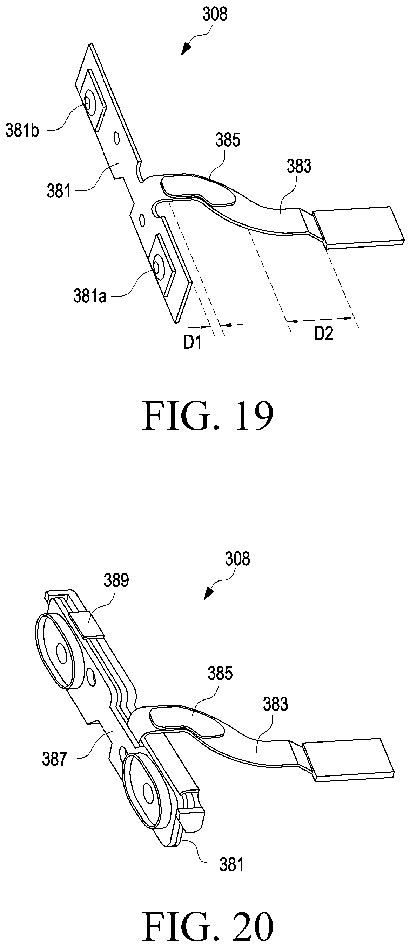

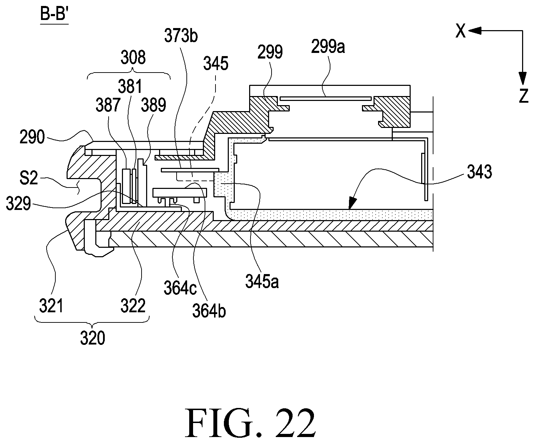

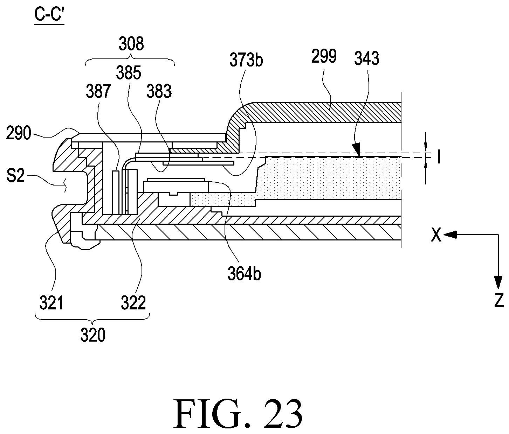

In the structure illustrated in FIG. 18, an area indicated by "S1" may exemplify a space in which a keypad assembly to be described later (e.g., the keypad assembly 308 of FIG. 19 or FIG. 20) is disposed, and an area indicated by "S2" may exemplify a space in which a key (e.g., the button member 397 of FIG. 24) to be operated by a user to actuate the keypad assembly 308 is disposed. Until the key is disposed, the area S2 may be perceived by a user as a groove-shaped portion from the outside of the side wall 321. In an embodiment, in a portion facing switches of the keypad assembly 308 to be described later (e.g., the switches 381a and 381b of FIG. 19), the S2 area may have a through hole structure extending from the outer surface of the side wall 321 to the area S1, and in a portion not facing the switches, the area S2may have a recess or groove shape as illustrated in FIG. 22 or FIG. 23. In an embodiment, the area S1 or the area S2 may be understood as being provided at least in part by the first portion 321a of the side wall 321.

According to an embodiment, the rear surface plate 290 may provide a through hole structure at a position corresponding to the third camera 343 (e.g., the camera assembly 304 of FIG. 10), thereby providing an imaging path or an optical path of the third camera 343. In an embodiment, to protect the third camera 343 (e.g., the camera assembly 304 of FIG. 10), the electronic device 200 and/or the rear surface plate 290 may further include a cover plate 299. In an embodiment, the cover plate 299 may be understood as a portion of the rear surface plate 290.

According to an embodiment, the cover plate 299 may be disposed on at least a portion around the camera assembly 304 and may provide one or more optical holes at positions corresponding to cameras (e.g., the first camera 341, the second camera 342, and/or the third camera 343 of FIG. 10). In the illustrated embodiment, a structure in which a window plate 299a is disposed in the one or more optical holes of the cover plate 299 may be exemplified. In an embodiment, at least a portion of an edge of the cover plate 299 may be attached to or fixed to an inner surface of the rear surface plate 290, and at least a portion of an outer surface thereof may be exposed to the outside of the rear surface plate 290. In an embodiment, to harmonize with an exterior appearance of the electronic device 200 and/or the rear surface plate 290, or to enhance an aesthetic appearance of the electronic device 200, the cover plate 299 may be made of a metal material or may be finished with a metal material (e.g., by printing, coating, deposition, or plating).

Hereinafter, configurations and arrangements of the keypad assembly 308 will be described in further detail with reference to FIGS. 19 to 23.

FIG. 19 is a first perspective view illustrating a keypad assembly of an electronic device according to an embodiment of the disclosure. FIG. 20 is a second perspective view illustrating the keypad assembly of the electronic device according to an embodiment of the disclosure.

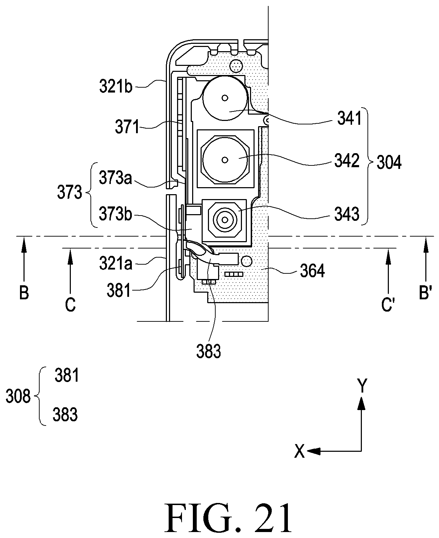

First, referring to FIGS. 19 and 20, the keypad assembly 308 may include a switch substrate 381 and a second flexible printed circuit board 383. The switch substrate 381 may include, for example, one or more switches 381a and 381b disposed on one surface thereof. In an embodiment, the switches 381a and 381b may be implemented as mechanical structures such as dome switches or tact switches, and in an embodiment, the switches 381a and 381b may be implemented as capacitive sensors or pressure-sensitive sensors. In an embodiment, the second flexible printed circuit board 383 may extend from the switch substrate 381 and may be electrically connected at an end thereof to the circuit board 364 of FIG. 21. As will be described later with reference to FIGS. 21 to 23, the second flexible printed circuit board 383 may be disposed to cross (or intersect with) the first flexible printed circuit board 373 or the extension portion 364b at one side of the camera assembly 304.

According to an embodiment, the electronic device 200 and/or the keypad assembly 308 may further include a second dummy member 385 disposed on the second flexible printed circuit board 383, thereby standardizing an arrangement of the second flexible printed circuit board 383 and/or the first flexible printed circuit board 373. For example, even in the presence of manufacturing tolerances or assembly tolerances, the second flexible printed circuit board 383 and/or the first flexible printed circuit board 373 may be disposed at a predetermined position and in a predetermined shape with respect to the rear surface plate 290 or the cover plate 299.

According to an embodiment, when the second dummy member 385 is positioned at a first distance from the switch substrate 381, the second dummy member 385 may be understood as being positioned at a second distance D2, which is greater than the first distance D1, from an end of the second flexible printed circuit board 383. As will be described later, a height difference may exist between the switch substrate 381 and the circuit board 364 on the housing 320. In this case, the second flexible printed circuit board 383 may be disposed to be partially inclined or to form a curved surface. The second dummy member 385 may be disposed on an area of the second flexible printed circuit board 383 in which a change in inclination is relatively small or a curvature is relatively small.

According to an embodiment, the electronic device 200 and/or the keypad assembly 308 may further include a protective plate 387 disposed on one surface of the switch substrate 381 and a protective bracket 389 disposed on the other surface of the switch substrate 381. As exemplified through FIG. 22 or FIG. 23, when the keypad assembly 308 is disposed on the housing 320, the protective plate 387 may be disposed between one surface of the switch substrate 381 and the side wall 321 (e.g., the first portion 321a) to protect the switch substrate 381, and the protective bracket 389 may prevent the other surface of the switch substrate 381 from being in direct contact with a structure of the side wall 321 or the support area 322. For example, the switch substrate 381 may be disposed or fixed inside the side wall 321 substantially by the protective plate 387 and the protective bracket 389. In an embodiment, the protective plate 387 may be made of an elastic material such as rubber or silicone, thereby providing a waterproof/dustproof structure at the S2 area of the through hole structure or at an inner surface of the side wall 321.

FIG. 21 is a view illustrating a state in which the keypad assembly of FIG. 19 or FIG. 20 is disposed in a housing of an electronic device according to an embodiment of the disclosure. FIG. 22 is a cross-sectional view illustrating a portion of the electronic device according to an embodiment of the disclosure, taken along line B-B' of FIG. 21. FIG. 23 is a cross-sectional view illustrating a portion of the electronic device according to an embodiment of the disclosure, taken along line C-C' of FIG. 21.

FIGS. 22 and 23 exemplify a rear surface plate 290 (e.g., the second rear surface plate 290 of FIG. 4) or a cover plate 299, but it should be noted that, in FIG. 21, the rear surface plate 290 or the cover plate 299 is omitted in order to exemplify arrangement of the camera assembly 304, the antenna module 307, and/or the keypad assembly 308.

Referring further to FIGS. 21 to 23, the keypad assembly 308 may be disposed in an inner space (e.g., the area S1 of FIG. 18) of the housing 320 so as to face the side wall 321 (e.g., the first portion 321a). In an embodiment, the expression "the keypad assembly 308 is disposed to face the side wall" may refer to a configuration in which the switch substrate 381 or one or more switches 381a and 381b are disposed to face an inner surface of the side wall 321. In an embodiment, the switch substrate 381 may be stably disposed on a structure provided by the housing 320 (e.g., the side wall 321 or the support area 322) by the protective plate 387 and/or the protective bracket 389. In an embodiment, the second flexible printed circuit board 383 may be disposed on the circuit board 364 in a bent state relative to the switch substrate 381. For example, when the switch substrate 381 is disposed to be oriented toward the side wall 321, the second flexible printed circuit board 383 may be understood as being disposed to be oriented toward the front surface (e.g., the second front surface 220a of FIG. 2) or the rear surface (e.g., the second rear surface 220b of FIG. 2) of the electronic device 200.

According to an embodiment, the second flexible printed circuit board 383 may be partially aligned to substantially face the circuit board 364 with the first flexible printed circuit board 373 interposed therebetween, and an end thereof may be electrically (and/or mechanically) connected to the circuit board 364. For example, the second flexible printed circuit board 383 may be disposed on the circuit board 364 so as to cross a portion of the first flexible printed circuit board 373 (or to intersect a portion of the first flexible printed circuit board 373). In an embodiment, the first flexible printed circuit board 373 may be understood as being connected to the circuit board 364 at an end thereof while being disposed to sequentially cross an area in which the contact piece 329 (or the contact terminal 364c) is disposed and an area in which the second flexible printed circuit board 383 (or the second dummy member 385) is disposed.

According to an embodiment, when the circuit board 364 is disposed on the housing 320 (e.g., the support area 322), the contact terminal 364c and the contact piece 329 may be in mechanical and/or electrical contact with each other. By storing elastic force as the contact terminal 364c is deformed while being in contact with the contact piece 329, the contact state may be maintained more stably. In an embodiment, the elastic force stored in the contact terminal 364c may press the circuit board 364 (e.g., the extension portion 364b) in the -Z direction. When the elastic force of the contact terminal 364c acts on a structure in which the extension portion 364b has a relatively small length or width (e.g., a length or width within several millimeters), the extension portion 364b may be deformed or damaged. In an embodiment, the support plate 364d of FIG. 13 or FIG. 14 may support the extension portion 364b on the other surface of the extension portion 364b, thereby suppressing deformation of the extension portion 364b caused by the elastic force of the contact terminal 364c while more stably maintaining a contact state between the contact terminal 364c and the contact piece 329.

According to an embodiment, the rear surface plate 290 may provide a through hole structure at a position corresponding to the third camera 343 (e.g., the camera assembly 304 of FIG. 10), thereby providing an imaging path or an optical path of the third camera 343 (e.g., the camera assembly 304 of FIG. 10). In an embodiment, to protect the third camera 343 (e.g., the camera assembly 304 of FIG. 10), the electronic device 200 and/or the rear surface plate 290 may further include a cover plate 299. In an embodiment, the cover plate 299 may be understood as a portion of the rear surface plate 290.

According to an embodiment, the cover plate 299 may be disposed on at least a portion around the third camera (e.g., the camera assembly 304 of FIG. 10) and may provide one or more optical holes at positions corresponding to cameras (e.g., the first camera 341, the second camera 342, and/or the third camera 343 of FIG. 10). In the illustrated embodiment, a structure in which a window plate 299a is disposed in the one or more optical holes of the cover plate 299 may be exemplified. In an embodiment, at least a portion of an edge of the cover plate 299 may be attached to or fixed to an inner surface of the rear surface plate 290, and at least a portion of an outer surface thereof may be exposed to the outside of the rear surface plate 290. In an embodiment, to harmonize with an exterior appearance of the electronic device 200 and/or the rear surface plate 290, or to enhance an aesthetic appearance of the electronic device 200, the cover plate 299 may be made of a metal material or may be finished with a metal material (e.g., by printing, coating, deposition, or plating).

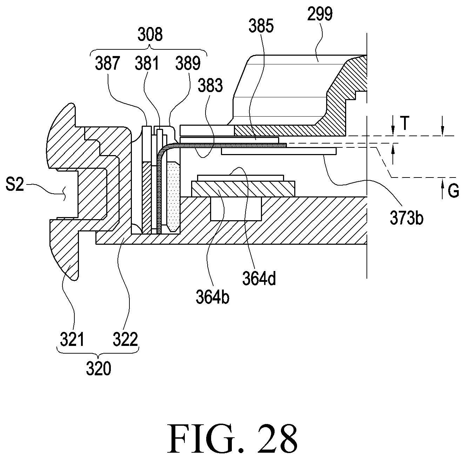

According to an embodiment, on the circuit board 364 or on an inner side of the rear surface plate 290, the second dummy member 385 may be disposed to face or to be in contact with at least a portion of an inner surface of the cover plate 299. For example, the second dummy member 385 may maintain a gap I (e.g., the thickness T of FIG. 28) between the second flexible printed circuit board 383 and the cover plate 299. In an embodiment, the first flexible printed circuit board 373 may be disposed to overlap the second flexible printed circuit board 383 in an area in which the second dummy member 385 is disposed. For example, by providing the second dummy member 385 and the second flexible printed circuit board 383, the first flexible printed circuit board 373 may be disposed on the circuit board 364 (e.g., the extension portion 364b of FIGS. 12 to 14) in a designed shape and may be positioned at a predetermined distance from the rear surface plate 290 and/or the cover plate 299.

According to an embodiment, the camera assembly 304, for example, the third camera 343, may further include a flange portion 345a connected to the support protrusion 345 on an outer peripheral surface where the support protrusion 345 is provided. In an embodiment, the support protrusion 345 may be understood as a portion of the flange portion 345a, and the flange portion 345a may have a structure including a portion that protrudes further than a remaining portion of the flange portion 345a at a position corresponding to a bent portion of the first flexible printed circuit board 373. A portion of the first flexible printed circuit board 373 (e.g., the second alignment portion 373b) extending from the bent portion to an end connected to the circuit board 364 may be supported by the flange portion 345a so as to be positioned at a predetermined distance from the rear surface plate 290 and/or the cover plate 299 while maintaining the designed shape.

According to an embodiment, when the first flexible printed circuit board 373 functions as a transmission line for an analog signal (e.g., a wireless communication signal), an induced current may be generated in surrounding electrically conductive structures. When an induced current is generated, efficiency of signal transmission may be reduced or quality of wireless communication may be degraded due to distortion of a transmitted signal. By providing various types of electromagnetic shielding structures, generation of such an induced current or electromagnetic interference may be suppressed. In an embodiment, by providing the second dummy member 385 and the second flexible printed circuit board 383, the first flexible printed circuit board 373 may be positioned at a predetermined distance from the rear surface plate 290 and/or the cover plate 299, thereby suppressing generation of an induced current.

In an embodiment, when the first flexible printed circuit board 373 in the form of a thin film is disposed differently from a designed shape, variation in wireless communication performance may occur among different electronic devices manufactured with the same specifications. In the embodiment(s) of the disclosure, by disposing the first flexible printed circuit board 373 in the designed shape using the support protrusion 345, the flange portion 345a, and/or the dummy members 375 and 385, degradation of wireless communication performance or variation in wireless communication performance may be suppressed even when a structure including a metal material or an electrically conductive material (e.g., the cover plate 299) is disposed adjacent thereto.

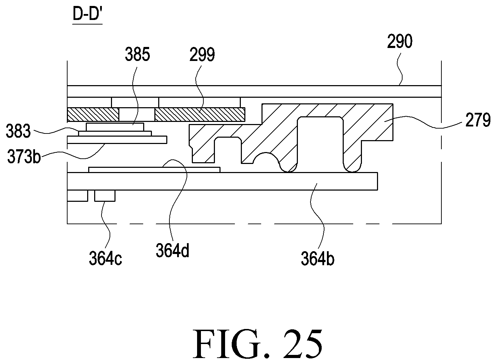

FIG. 24 is a view illustrating a state in which one or more flexible printed circuit boards are disposed in an electronic device according to an embodiment of the disclosure. FIG. 25 is a cross-sectional view illustrating a portion of the electronic device according to an embodiment of the disclosure, taken along line D-D' of FIG. 24.

Referring to FIGS. 24 and 25, the rear member 270 of FIG. 4 may stably maintain an arrangement structure or a connection state of various components within the housing 320. For example, in the rear member 270, a support portion indicated by reference numeral 279 and/or one or more other portions may support a portion of a circuit board 364 or support an end of a first flexible printed circuit board 373 and/or an end of a second flexible printed circuit board 383, thereby stably maintaining a state in which the first flexible printed circuit board 373 and/or the second flexible printed circuit board 383 are connected to a circuit board 364. In an embodiment, although not assigned with a reference numeral, a support portion 379 may be disposed to be in direct contact with the circuit board 364 or a support plate 364d through a protrusion formed on a surface facing the circuit board 364. Accordingly, the circuit board 364 may be stably fixed by the support area 322 and the rear member 270, and deformation of or damage to the extension portion 364b may be suppressed.

According to an embodiment, a button member 397 may be disposed in the area S2 of FIG. 18, FIG. 22, and/or FIG. 23, and may protrude by a predetermined height from an outer surface of the side wall 321 (e.g., the first portion 321a). A height by which the button member 397 protrudes from the outer surface of the side wall 321 may be determined, for example, by a movement distance of the button member 397 required to actuate one or more switches 381a and 381b of the keypad assembly 308.

FIG. 26 is a first view illustrating a state in which a cover plate is disposed in an electronic device according to an embodiment of the disclosure. FIG. 27 is a second view illustrating a state in which the cover plate is disposed in the electronic device according to an embodiment of the disclosure.

Referring to FIGS. 26 and 27, as described above, when wiring through which an analog signal is transmitted (e.g., the first flexible printed circuit board 373 of FIG. 15 and/or FIGS. 22 to 25) is disposed adjacent to an electrically conductive structure such as the cover plate 299, an induced current or electromagnetic interference may occur, thereby degrading wireless communication performance. In the embodiment(s) of the disclosure, in suppressing electromagnetic interference that may occur between the first flexible printed circuit board 373 and an electrically conductive structure, the second flexible printed circuit board 383 may be disposed between the second alignment portion 373b (e.g., the first flexible printed circuit board 373) and the cover plate 299, and the second dummy member 385 may be disposed between the second flexible printed circuit board 383 and the cover plate 299 and/or between the second alignment portion 373b (e.g., the first flexible printed circuit board 373) and the cover plate 299. For example, by providing a predetermined gap between the first flexible printed circuit board 373 and the cover plate 299, electromagnetic interference that may occur between the second alignment portion 373b (e.g., the first flexible printed circuit board 373) and the cover plate 299 may be suppressed.

According to an embodiment, by reducing an area in which the second alignment portion 373b (e.g., the first flexible printed circuit board 373) and the cover plate 299 face each other (or an area in which the second alignment portion 373b and the cover plate 299 overlap), electromagnetic interference or generation of an induced current between the second alignment portion 373b (e.g., the first flexible printed circuit board 373) and the cover plate 299 may be suppressed. In an embodiment, the cover plate 299 may provide a notch portion 299b that extends inward from one edge thereof. The notch portion 299b may be implemented, for example, by removing a portion of the cover plate 299, and may be disposed at a position overlapping the second dummy member 385, the first flexible printed circuit board 373 (e.g., the second alignment portion 373b), and/or the second flexible printed circuit board 383. In an embodiment, the second dummy member 385 may be understood as being disposed, at least in part, between the notch portion 299b and the first flexible printed circuit board 373 (e.g., the second alignment portion 373b), or between the notch portion 299b and the second flexible printed circuit board 383. For example, the second dummy member 385 may be understood as being disposed to face the cover plate 299 across an area in which the notch portion 299b is disposed.

According to an embodiment, the notch portion 299b may be understood as being implemented by providing a protrusion 299c on one edge of the cover plate 299. For example, the protrusion 299c may extend outward from one side of the cover plate 299 so as to surround at least a portion of the notch portion 299b. In an embodiment, the protrusion 299c may be disposed in an area that does not substantially overlap the second dummy member 385, the first flexible printed circuit board 373 (e.g., the second alignment portion 373b), and/or the second flexible printed circuit board 383.

According to an embodiment, the second dummy member 385 may be manufactured to have a predetermined size and may be disposed at a predetermined position on the second flexible printed circuit board 383. In an embodiment, an end of the second flexible printed circuit board 383 may be understood as being connected to the switch substrate 381, and another end thereof may be directly connected to the circuit board 364. In this case, due to a height difference between the switch substrate 381 and the circuit board 364, a portion of the second flexible printed circuit board 383 may be disposed on the circuit board 364 in an inclined shape or in a curved shape. As a portion of the second flexible printed circuit board 383 is closer to the switch substrate 381 or closer to a connection portion with the circuit board 364, a partial inclination angle or curvature of the second flexible printed circuit board 383 may increase. In an embodiment, the second dummy member 385 may be disposed in a portion of the second flexible printed circuit board 383 where the inclination angle or curvature is relatively small. In an embodiment, the second dummy member 385 may be understood as being disposed closer than to the switch substrate 381 than to the end of the second flexible printed circuit board 383.

According to an embodiment, in a portion adjacent to the switch substrate 381, the second flexible printed circuit board 383 may be bent at a predetermined angle (e.g., about 90 degrees), and may be connected at an end thereof to the circuit board 364 while forming a gentle inclination between the circuit board 364 and the cover plate 299. In an embodiment, an area of the second flexible printed circuit board 383 in which the second dummy member 385 is disposed may be arranged to be substantially parallel to the circuit board 364 or the cover plate, and an area of the second flexible printed circuit board 383 between the second dummy member 385 and a portion connected to the circuit board 364 may be arranged to be inclined with respect to the circuit board 364 or to have a curved shape.

FIG. 28 is a view illustrating a state in which a dummy member is disposed on an inner side of a cover plate 299 in an electronic device according to an embodiment of the disclosure.

Referring to FIG. 28, when, as described above, the antenna module (e.g., the antenna module 308 of FIG. 15) and/or the keypad assembly (e.g., the keypad assembly 308 of FIG. 19 or FIG. 20) are disposed on a housing 320, the first flexible printed circuit board 373 (e.g., the second alignment portion 373b) and/or the second flexible printed circuit board 383 may be disposed to at least partially face the cover plate 299. The first flexible printed circuit board 373 or the second flexible printed circuit board 383, which is manufactured in the form of a film, may have slight differences in position or shape on the housing 320 depending on a product, even among electronic devices having the same specifications, due to manufacturing tolerances or assembly tolerances. In an embodiment, although an electromagnetic shielding structure may be sufficiently provided, when a distance between the first flexible printed circuit board 373, which transmits an analog signal (e.g., a wireless communication signal), and the cover plate 299 including an electrically conductive material varies depending on a product, a variation in wireless communication performance may occur.

In the electronic device 200 according to the embodiment(s) of the disclosure, by including the second dummy member 385, it may be possible to standardize an assembly position or a shape of the first flexible printed circuit board 373 and/or the second flexible printed circuit board 383. For example, by disposing the second flexible printed circuit board 383 and/or the second dummy member 385 between the first flexible printed circuit board 373 and the cover plate 299, a gap G between the first flexible printed circuit board 373 and the cover plate 299 may be maintained to be equal to or greater than a predetermined size. Here, the expression "a gap G equal to or greater than a predetermined size" may refer to a gap of a magnitude sufficient to minimize generation of an induced current in the cover plate 299 when power or an electrical signal is transmitted through the first flexible printed circuit board 373 (or the second flexible printed circuit board 383). In an embodiment, the expression "a gap G equal to or greater than a predetermined size" may refer to a gap capable of minimizing electromagnetic coupling generated between the first flexible printed circuit board 373 and the cover plate 299 or between the second flexible printed circuit board 383 and the cover plate 299 when power or an electrical signal is transmitted through the first flexible printed circuit board 373 (or the second flexible printed circuit board 383). For example, by disposing, at least in part, the second flexible printed circuit board 383 and/or the second dummy member 385 between the first flexible printed circuit board 373 and the cover plate 299, formation of electromagnetic coupling between the first flexible printed circuit board 373 and the cover plate 299 or generation of an induced current in the cover plate 299 may be suppressed.

Before the second dummy member 385 is disposed, when the side wall 321, for example, the first portion 321a of FIG. 14, functions as a radiating conductor, a null section having a radiation efficiency of about -16 dB or less at a frequency of about 2 GHz was generated. According to the embodiment(s) of the disclosure, when the second dummy member 385 is disposed and the first area 321a functions as a radiating conductor, it has been identified that radiation efficiency at a frequency of about 2 GHz is improved by about 3 dB and that a null phenomenon is improved. In a structure in which the second dummy member 385 is disposed and the second region 321b functions as a radiating conductor, it has been identified that radiation efficiency in a frequency band of about 850 MHz and/or about 900 MHz is improved by about 0.5 to 1 dB.

According to an embodiment, when the keypad assembly 308 is disposed on the housing 320 and connected to the circuit board 364 without interference with an external structure (e.g., the second dummy member 385 or the cover plate 299), the second flexible printed circuit board 373 may be disposed to form a gentle inclination or a curved trajectory from the switch substrate 381 to a connection portion with the circuit board 364. As described above, such an inclined shape or curved shape of the second flexible printed circuit board 373 may cause a variation in a distance from the cover plate 299 (e.g., the gap G illustrated in FIG. 28) depending on manufacturing tolerances or assembly tolerances. By being disposed on the second flexible printed circuit board 373 so as to face (or be in contact with) the cover plate 299, the second dummy member 385 may suppress variations in the gap G between products. For example, even different products having the same specifications may have substantially equivalent quality (or equivalent wireless communication performance).

According to an embodiment, a portion of the second flexible printed circuit board 383 adjacent to the switch substrate 381 may be disposed to form a predetermined angle (e.g., about 90 degrees) with respect to the switch substrate 381, and, by disposing (or attaching) the second dummy member 385, the second flexible printed circuit board 383 may be disposed in a substantially flat plate shape. The second dummy member 385 may be disposed on the second flexible printed circuit board 373 so as to face or be in contact with the cover plate 299. For example, the second flexible printed circuit board 373 (or the first flexible printed circuit board 383) may be disposed between the circuit board 364 and the cover plate 299 and may be positioned at a predetermined distance (e.g., a gap G) from the cover plate 299. In an embodiment, on an inner side of the cover plate 299, at least an area of the second flexible printed circuit board 373 in which the second dummy member 385 is disposed may maintain a substantially flat plate shape.

According to an embodiment, the second dummy member 385 may be a foam tape made of a polymer material such as acrylic, and may be manufactured in consideration of the shape of the second flexible printed circuit board 383. In an embodiment, by having a predetermined thickness T, the second dummy member 385 may maintain the gap (e.g., the gap I of FIG. 23) between the second flexible printed circuit board 383 and the cover plate 299 to be about 0.1 mm or more and about 0.5 mm or less. However, since the second dummy member 385 may be made of an elastic material such as a foam tape, it should be noted that, in a state in which the second dummy member 385 is disposed on the housing 320, the numerical values related to the thickness T or the gap described above do not limit the embodiment(s) of the disclosure. According to an embodiment, the second dummy member 385 may be positioned at a distance of about 0.06 mm from the cover plate 299, and thus may not substantially be in contact with the cover plate 299.

According to an embodiment, the second dummy member 385 may be manufactured to correspond to the shape of the second flexible printed circuit board 383. For example, when the second dummy member 385 is disposed in a curved section of the second flexible printed circuit board 383 when viewed in a plan view, the second dummy member 385 may have a shape corresponding to the curved section of the second flexible printed circuit board 383. In an embodiment, in a structure in which the second dummy member 385 is attached to the second flexible printed circuit board 383, for example, in a structure in which an adhesive material is provided, the second dummy member 385 may be manufactured to have a size smaller than the width or the length of the second flexible printed circuit board 383. For example, the second dummy member 385 may be manufactured to have a size or a shape such that the second dummy member 385 is disposed inward by about 0.2 mm from an edge of the second flexible printed circuit board 383. This may be to suppress contamination of an inner space of the electronic device 200 by an adhesive material for attaching the second dummy member 385.

As described above, as an antenna module (e.g., the antenna module 307 of FIGS. 15 to 17) is disposed in a confined space while suppressing a change in a shape of transmission wiring, an electronic device (e.g., the electronic devices 101 and 200 of FIGS. 1 to 4) may be provided with a stable wireless communication environment. For example, in electronic devices having the same specifications, by standardizing an arrangement and a shape of a transmission line leading to an antenna module, variations in wireless communication performance among different products may be suppressed, and consumer reliability may be ensured.

Effects obtainable from the disclosure are not limited to the effects described above, and other effects not explicitly mentioned may be clearly understood by a person having ordinary skill in the art to which the disclosure pertains from the description of the above-described embodiment(s).

According to an embodiment of the disclosure, an electronic device (e.g., the electronic device 101 or 200 of FIGS. 1 to 4) may include a housing (e.g., the second housing 220 of FIGS. 2 to 4 or the housing 320 of FIG. 14) including a front surface (e.g., the second front surface 220a of FIG. 2), a rear surface (e.g., the second rear surface 220b of FIG. 2) facing opposite to the front surface, and a side wall (e.g., the second side wall 221 of FIG. 4 or the side wall 321 of FIG. 14) at least partially surrounding a space between the front surface and the rear surface, a camera assembly (e.g., the camera assembly 204 or 304 of FIG. 4, FIG. 7, FIG. 10, and/or FIG. 14) disposed adjacent to the side wall at one edge of the space, a cover plate (e.g., the cover plate 299 of FIG. 4, FIG. 22, FIG. 23, FIG. 26, and/or FIG. 27) disposed on at least a portion of a circumference of the camera assembly and at least partially exposed to the outside through the rear surface, a keypad assembly (e.g., the keypad assembly 308 of FIGS. 19 to 24) disposed between a first portion (e.g., the first portion 321a of FIG. 14) of the side wall adjacent to the camera assembly and the camera assembly, and an antenna module (e.g., the antenna module 307 of FIGS. 15 to 17) having a portion disposed between a second portion (e.g., the second portion 321b of FIG. 14) of the side wall adjacent to the first portion and the camera assembly, the antenna module including a first flexible printed circuit board (e.g., the first flexible printed circuit board 373 of FIGS. 15 to 17) at least partially disposed between the first portion and the camera assembly. In an embodiment, the keypad assembly may include a switch substrate (e.g., the switch substrate 381 of FIG. 19) at least partially disposed between the first portion and the camera assembly, a second flexible printed circuit board (e.g., the second flexible printed circuit board 383 of FIG. 19) extending from the switch substrate and disposed to cross the first flexible printed circuit board at one side of the camera assembly, and a dummy member (e.g., the second dummy member 385 of FIG. 19, FIG. 20, or FIG. 26) disposed on the second flexible printed circuit board while at least partially facing the cover plate.

According to an embodiment, the cover plate may include a protrusion (e.g., the protrusion 299c of FIG. 26) extending from an edge of the cover plate to the outside of the cover plate to provide a notch portion (e.g., the notch portion 299b of FIG. 26) at least partially surrounded by the protrusion. In an embodiment, a portion of the dummy member may be disposed between the notch portion and the first flexible printed circuit board, or between the notch portion and the second flexible printed circuit board.

According to an embodiment, a portion of the second flexible printed circuit board may be disposed between the first flexible printed circuit board and the cover plate.

According to an embodiment, the above-described electronic device may further include a processor (e.g., the processor 120 of FIG. 1) or a communication module (e.g., the communication module 190 of FIG. 1) configured to perform wireless communication using at least one of the first portion, the second portion, or the antenna module.

According to an embodiment, the side wall may include an insulating structure (e.g., the insulating structure 321c of FIG. 14, FIG. 16, and/or FIG. 17) disposed between the first portion and the second portion.

According to an embodiment, the above-described electronic device may further include a circuit board (e.g., the second circuit board 264 of FIG. 4 and/or the circuit board 364 of FIGS. 12 to 14) disposed in a space between the front surface and the rear surface and providing an opening area (e.g., the opening area 364a of FIGS. 12 and/or 13) configured to accommodate a portion of the camera assembly. In an embodiment, an end of the second flexible printed circuit board may be connected to the circuit board.

According to an embodiment, the dummy member may be disposed at a first distance from the switch substrate and may be positioned at a second distance from the end of the second flexible printed circuit board. In an embodiment, the first distance may be smaller than the second distance.

According to an embodiment, the above-described electronic device may further include an extension portion (e.g., the extension portion 364b of FIGS. 12 to 14), which is a portion of the circuit board and defines a portion of the opening area, the extension portion being at least partially disposed between the first portion and the camera assembly. In an embodiment, the dummy member may be disposed between the extension portion and the cover plate.

According to an embodiment, the above-described electronic device may further include a contact piece (e.g., the contact piece 329 of FIG. 8, FIG. 9, and/or FIG. 14) extending from the side wall at the first portion and disposed to at least partially face the extension portion. In an embodiment, the first portion may be electrically connected to the circuit board through the contact piece.

According to an embodiment, the first flexible printed circuit board may be disposed to sequentially cross an area where the contact piece is disposed and an area where the second flexible printed circuit board is disposed, and an end of the first flexible printed circuit board may be connected to the circuit board.

According to an embodiment, the extension portion may be at least partially disposed between the contact piece and the first flexible printed circuit board.

According to an embodiment, the above-described electronic device may further include a contact terminal (e.g., the contact terminal 364c of FIG. 12 or 22) disposed on one surface of the extension portion and electrically connected to the contact piece. In an embodiment, the first portion may be configured to receive a feeding signal through the contact terminal and the contact piece.

According to an embodiment of the disclosure, an electronic device (e.g., the electronic device 101 or 200 of FIGS. 1 to 4) may include a housing (e.g., the second housing 220 of FIGS. 2 to 4 or the housing 320 of FIG. 14) including a front surface (e.g., the second front surface 220a of FIG. 2), a rear surface (e.g., the second rear surface 220b of FIG. 2) facing opposite to the front surface, and a side wall (e.g., the second side wall 221 of FIG. 4 or the side wall 321 of FIG. 14) at least partially surrounding a space between the front surface and the rear surface, a camera assembly (e.g., the camera assembly 204 or 304 of FIG. 4, FIG. 7, FIG. 10, and/or FIG. 14) disposed adjacent to the side wall at one edge of the space, a cover plate (e.g., the cover plate 299 of FIG. 4, FIG. 22, FIG. 23, FIG. 26, and/or FIG. 27) disposed on at least a portion of a circumference of the camera assembly and at least partially exposed to the outside through the rear surface, the cover plate providing a notch portion (e.g., the notch portion 299b of FIG. 26) that is at least partially surrounded by a protrusion (e.g., the protrusion 299c of FIG. 26) extending outward from an edge of the cover plate, a keypad assembly (e.g., the keypad assembly 308 of FIGS. 19 to 24) disposed between a first portion (e.g., the first portion 321a of FIG. 14) of the side wall adjacent to the camera assembly and the camera assembly, and an antenna module (e.g., the antenna module 307 of FIGS. 15 to 17) having a portion disposed between a second portion (e.g., the second portion 321b of FIG. 14) of the side wall adjacent to the first portion and the camera assembly, the antenna module including a first flexible printed circuit board (e.g., the first flexible printed circuit board 373 of FIGS. 15 to 17) at least partially disposed between the first portion and the camera assembly. In an embodiment, the keypad assembly may include a switch substrate (e.g., the switch substrate 381 of FIG. 19) at least partially disposed between the first portion and the camera assembly, a second flexible printed circuit board (e.g., the second flexible printed circuit board 383 of FIG. 19) extending from the switch substrate and disposed to cross the first flexible printed circuit board at one side of the camera assembly, and a dummy member (e.g., the second dummy member 385 of FIG. 19, FIG. 20, or FIG. 26) disposed on the second flexible printed circuit board and disposed to face the cover plate across an area in which the notch portion is disposed.

According to an embodiment, a portion of the first flexible printed circuit board may be aligned to face at least one of the notch portion or the cover plate with the dummy member interposed therebetween.

According to an embodiment, the above-described electronic device may further include a circuit board (e.g., the second circuit board 264 of FIG. 4 and/or the circuit board 364 of FIGS. 12 to 14) disposed in a space between the front surface and the rear surface and providing an opening area (e.g., the opening area 364a of FIGS. 12 and/or 13) configured to accommodate a portion of the camera assembly. In an embodiment, the dummy member may be disposed at a first distance from the switch substrate, and an end of the second flexible printed circuit board may be electrically connected to the circuit board at a position at a second distance from the dummy member. In an embodiment, the first distance may be smaller than the second distance.

According to an embodiment, in the above-described electronic device, the circuit board may further include an extension portion (e.g., the extension portion 364b of FIGS. 12 to 14) disposed between the camera assembly and the first portion. In an embodiment, at least a portion of the dummy member, at least a portion of the first flexible printed circuit board, or at least a portion of the second flexible printed circuit board may be disposed between the extension portion and the cover plate.

According to an embodiment, in an area between the cover plate and the circuit board, an end of the second flexible printed circuit board may be electrically connected to the circuit board.

According to an embodiment, the dummy member may be configured to maintain a gap of not less than 0.1 mm and not more than 0.5 mm between the second flexible printed circuit board and the cover plate.

Although the disclosure has been described with reference to an embodiment as an example, it is to be understood that the embodiment is intended to be exemplary and is not limiting the disclosure. It will be apparent to those skilled in the art that various changes in form and detail may be made without departing from the overall scope of the disclosure, including the appended claims and their equivalents.

## Claims

1. An electronic device (101; 200) comprising:
a housing (220; 320) including a front surface (220a), a rear surface (220b) facing opposite to the front surface, and a side wall (221; 321) at least partially surrounding a space between the front surface and the rear surface;
a camera assembly (204; 304) disposed adjacent to the side wall at one edge of the space;
a cover plate (299) disposed on at least a portion of the circumference of the camera assembly and at least partially exposed to an outside through the rear surface;
a keypad assembly (308) at least partially disposed between a first portion (321a) of the side wall adjacent to the camera assembly and the camera assembly; and
an antenna module (307) partially disposed between a second portion (321b) of the side wall adjacent to the first portion and the camera assembly, wherein the antenna module includes a first flexible printed circuit board (373) at least partially disposed between the first portion and the camera assembly,
wherein the keypad assembly includes:
a switch substrate (381) at least partially disposed between the first portion and the camera assembly,
a second flexible printed circuit board (383) extending from the switch substrate and disposed at one side of the camera assembly to cross the first flexible printed circuit board, and
a dummy member (385) disposed on the second flexible printed circuit board while at least partially facing the cover plate.

2. The electronic device of claim 1, wherein the cover plate includes a protrusion (299c) extending from an edge of the cover plate to an outside of the cover plate to provide a notch portion (299b) partially surrounded by the protrusion, and
wherein a portion of the dummy member is disposed between the notch portion and the first flexible printed circuit board, or between the notch portion and the second flexible printed circuit board.

3. The electronic device of one of claims 1 to 2, wherein a portion of the second flexible printed circuit board is disposed between the first flexible printed circuit board and the cover plate.

4. The electronic device of any one of claims 1 to 3, further comprising:
a processor (120) or a communication module (190) configured to perform wireless communication using at least one of the first portion, the second portion, or the antenna module.

5. The electronic device of claim 4, wherein the sidewall includes an insulating structure (321c) disposed between the first portion and the second portion.

6. The electronic device of any one of claims 1 to 5, further comprising:
a circuit board (264; 364) disposed in the space between the front surface and the rear surface and providing an opening area (364a) configured to accommodate a portion of the camera assembly,
wherein an end of the second flexible printed circuit board is connected to the circuit board.

7. The electronic device of claim 6, wherein the dummy member is disposed at a first distance (D1) from the switch substrate and disposed at a second distance (D2) from an end of the second flexible printed circuit board, and
wherein the first distance is smaller than the second distance.

8. The electronic device of any one of claims 6 to 7, further comprising:
an extension portion (364b), which is a portion of the circuit board, defining a portion of the opening area and at least partially disposed between the first portion and the camera assembly, and
wherein the dummy member is disposed between the extension portion and the cover plate.

9. The electronic device of claim 8, further comprising:
a contact piece (329) extending from the side wall in the first portion and disposed to at least partially face the extension portion,
wherein the first portion is electrically connected to the circuit board through the contact piece.

10. The electronic device of claim 9, wherein the first flexible printed circuit board is disposed to sequentially cross an area where the contact piece is disposed and an area where the second flexible printed circuit board is disposed, and
wherein an end of the first flexible printed circuit board is connected to the circuit board.

11. The electronic device of any one of claims 9 to 10, wherein the extension portion is at least partially disposed between the contact piece and the first flexible printed circuit board.

12. The electronic device of any one of claims 9 to 11, further comprising:
a contact terminal (364d) disposed on one surface of the extension portion and electrically connected to the contact piece,
wherein the first portion is configured to receive a feeding signal through the contact terminal and the contact piece.

13. The electronic device of any one of claims 1 to 12, further comprising:
a second housing;
a hinge structure (202) configured to rotatably couple the second housing to the housing and to provide at least one folding axis (A) that becomes a rotation center of the housing or the second housing; and
a flexible printed circuit board (266) disposed from an inside of the housing to an inside of the second housing across the hinge structure.

14. The electronic device of claim 13, further comprising:
a flexible display (230) including a first display area (231) disposed in one of the housing and the second housing, a second display area (232) disposed in another one of the housing and the second housing, and a folding area (233) disposed on the hinge structure,
wherein the flexible display is configured to output a screen through at least a portion of the front surface of the housing.

15. The electronic device of claim 1, wherein the dummy member is configured to maintain a gap of not less than 0.1mm and not more than 0.5mm between the second flexible printed circuit board and the cover plate.
